# EUROPEAN PATENT APPLICATION

(11) **EP 4 704 528 A1**
(43) Date of publication of application: **04.03.2026**
(21) Application number: 25179782.5
(22) Date of filing: 30.05.2025
(51) Int. Cl.: H10H 29/01, H10H 29/39, H10H 29/80, H01L 25/16, H10H 29/49, H10H 29/853, H10H 29/855

(54) **DISPLAY DEVICE AND METHOD FOR MANUFACTURING THE SAME**

(30) Priority: 29.08.2024 KR 20240116974
(71) Applicant: LG Display Co., Ltd., Seoul, 07336 (KR)
(72) Inventor: CHUNG, Bogyun, 10845 Paju-si (KR); SON, HyeonHo, 10845 Paju-si (KR); KIM, Seok, 10845 Paju-si (KR); KIM, YoonSeok, 10845 Paju-si (KR); LEE, Jaekyung, 10845 Paju-si (KR)
(74) Representative: Ter Meer Steinmeister & Partner

(57) **Abstract**

The disclosure relates to a display device and to a corresponding manufacturing method. The display device comprises: a substrate (110) in which a plurality of sub pixels (SP) including a first sub pixel (SP1) is defined, a power line (VL) disposed on the substrate, a driving transistor (DT) disposed in the first sub pixel on the substrate, a first reflection electrode (RE1) and a second reflection electrode (RE2) disposed on the driving transistor in the first sub pixel, a first light emitting diode (LED1) disposed on one of the first reflection electrode and the second reflection electrode in the first sub pixel, a first connection electrode (CE1) electrically connected to the power line, a second connection electrode (CE2) electrically connected to the driving transistor, and a third connection electrode (CE3) which is electrically connected to one of the first connection electrode and the second connection electrode by the other one of the first reflection electrode and the second reflection electrode and is electrically connected to the first light emitting diode. Accordingly, a portion where a light emitting diode is not disposed may be repaired without a separate repair process.

## Description

This application claims the priority of Korean Patent Application No. 10-2024-0116974 filed on August 29, 2024, in the Korean Intellectual Property Office.

### Technical Field

The present disclosure relates to a display device, and more particularly to a display device including a sub pixel in which a plurality of light emitting diodes connected in series is disposed.

### Background Art

As display devices which are used for a monitor of a computer, a television, or a cellular phone, there are an organic light emitting display device (OLED) which is a self-emitting device and a liquid crystal display device (LCD) which requires a separate light source.

An applicable range of the display device is diversified to personal digital assistants as well as monitors of computers and televisions and a display device with a large display area and a reduced volume and weight is being studied.

Further, recently, a display device including a light emitting diode (LED) is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast lighting speed, excellent luminous efficiency, and a strong impact resistance so that a stability is excellent and an image having a high luminance can be displayed.

### SUMMARY

An object to be achieved by the present disclosure is to provide a display device in which a plurality of light emitting diodes is connected to each other in series in one sub pixel.

Another object to be achieved by the present disclosure is to provide a display device with improved power consumption.

Still another object to be achieved by the present disclosure is to provide a display device which is automatically repaired during the manufacturing process when any one light emitting diode is missing in one sub pixel.

Objects of the present disclosure are not limited to the above-mentioned objects, and other objects, which are not mentioned above, can be clearly understood by those skilled in the art from the following descriptions.

At least one of the above objects is solved by the features of the display device and the manufacturing method thereof according to the independent claims. Further embodiments are specified in the dependent claims.

According to an aspect of the present disclosure, a display device comprises a substrate in which a plurality of sub pixels including a first sub pixel is defined; a power line disposed on the substrate; a driving transistor disposed in the first sub pixel on the substrate; a conductive pattern which includes a first reflection electrode and a second reflection electrode disposed on the driving transistor in the first sub pixel; and a first light emitting diode disposed on the conductive pattern one of the first reflection electrode and the second reflection electrode in the first sub pixel, wherein the conductive pattern electrically connects the first light emitting diode and the power line or the driving transistor disposed in the first sub pixel. That is, the conductive pattern may electrically connect the first light emitting diode and the power line or the first light emitting diode and the driving transistor with each other. Accordingly, a portion where the light emitting diode is not disposed may be repaired without a separate repair process.

According to an aspect of the present disclosure, display device comprises a substrate in which a plurality of sub pixels including a first sub pixel is defined, a power line disposed on the substrate, a driving transistor disposed in the first sub pixel on the substrate, a first reflection electrode and a second reflection electrode disposed on the driving transistor in the first sub pixel, a first light emitting diode disposed on one of the first reflection electrode and the second reflection electrode in the first sub pixel, a first connection electrode electrically connected to the power line, a second connection electrode electrically connected to the driving transistor, and a third connection electrode which is electrically connected to one of the first connection electrode and the second connection electrode by the other one of the first reflection electrode and the second reflection electrode and is electrically connected to the first light emitting diode. Accordingly, a portion where the light emitting diode is not disposed may be repaired without a separate repair process.

According to another aspect of the present disclosure, a display device comprises a substrate including a plurality of sub pixels, a power line disposed on the substrate, a plurality of driving transistors disposed in each of the plurality of sub pixels on the substrate, a first light emitting diode disposed in a first sub pixel, among the plurality of sub pixels, a second light emitting diode and a third light emitting diode which are disposed in a second sub pixel among the plurality of sub pixels, emit same color light and are connected in series, and a conductive pattern which electrically connects the first light emitting diode and the power line or a driving transistor disposed in the first sub pixel, among the plurality of driving transistors, wherein the second light emitting diode is electrically connected to the power line and the third light emitting diode is electrically connected to the driving transistor disposed in the second sub pixel, among the plurality of driving transistors. Accordingly, a plurality of light emitting diodes is connected in series in one sub pixel so that power consumption may be reduced. Further, if any one light emitting diode is not transferred in one sub pixel, in a non-transferred area, the repair may be caused.

According to another aspect of the present disclosure, a method for manufacturing display device comprises: transferring, in a transfer process, the a first light emitting diode and the a second light emitting diode into a first region overlapping with a first reflection electrode on a substrate and a second region overlapping with a second reflection electrode on the substrate, respectively; forming a first planarization layer or both a first planarization layer and a black matrix, on the first region and the second region; performing an etching process the first planarization layer or the black matrix to expose at least a portion of the a component below the first planarization layer or the black matrix, in the first region and the second region; forming a second planarization layer on the first planarization layer or the black matrix, wherein pattering the second planarization layer is patterned so that a portion of the second planarization layer remains on a portion of the exposed surfaces in the first region and the second region; and forming a plurality of connection electrodes on the second planarization layer, wherein, in the case where the first light emitting diode is transferred to the first reflection electrode and the second light emitting diode is not transferred to the second reflection electrode during the transfer process, forming the second planarization layer is formed on the exposed second reflection electrode, and electrically connecting the first light emitting diode is electrically connected to a driving transistor or a power line on the substrate through connection electrodes among the plurality of connection electrodes and the second reflection electrode.

According to another aspect of the present disclosure, a method for manufacturing display device comprises: performing a transferring process to transferring the first light emitting diode and the second light emitting diode into a first region overlapping with a first reflection electrode on a substrate and a second region overlapping with a second reflection electrode on the substrate, respectively; forming a first planarization layer or both a first planarization layer and a black matrix, on the first region and the second region; performing an etching process to expose at least a portion of the component below the first planarization layer or the black matrix, in the first region and the second region; forming a second planarization layer on the first planarization layer or the black matrix, wherein the second planarization layer is patterned so that a portion of the second planarization layer remains on a portion of the exposed surfaces in the first region and the second region; and forming a plurality of connection electrodes on the second planarization layer, wherein, in the case where the first light emitting diode is transferred to the first reflection electrode and the second light emitting diode is not transferred to the second reflection electrode during the transfer process, the second planarization layer is formed on the exposed second reflection electrode, and the first light emitting diode is electrically connected to a driving transistor or a power line on the substrate through connection electrodes among the plurality of connection electrodes and the second reflection electrode.

The display device or method according to any of the above aspects may further include at least one of the following features:
The conductive pattern may further include: a first connection electrode electrically connected to the power line; and/or a second connection electrode electrically connected to the driving transistor. The conductive pattern may further include a third connection electrode which is electrically connected to one of the first connection electrode and the second connection electrode by the other one of the first reflection electrode and the second reflection electrode and is electrically connected to the first light emitting diode. In the following, the first connection electrode may be also called as first contact electrode. Similarly, the second connection electrode may be called as second contact electrode, and the third connection electrode may be called as third contact electrode.

The display device may further comprise an adhesive layer which is disposed on the first reflection electrode and the second reflection electrode in the first sub pixel. The adhesive layer may be disposed between the one of the first reflection electrode and the second reflection electrode and the first light emitting diode. The adhesive layer may include an opening which exposes the other one of the first reflection electrode and the second reflection electrode.

Each of the first connection electrode and the second connection electrode may be in contact with the other one of the first reflection electrode and the second reflection electrode exposed by the opening.

The display device may further comprise an insulating pattern which is disposed on the other one of the first reflection electrode and the second reflection electrode exposed through the opening.

The one of the first connection electrode and the second connection electrode may be spaced apart from the third connection electrode on the insulating pattern.

The one of the first connection electrode and the second connection electrode and the third connection electrode may be in contact with the other one of the first reflection electrode and the second reflection electrode exposed by the opening.

The display device may further comprise a first planarization layer which is disposed on the first reflection electrode and the second reflection electrode in the first sub pixel. and the display device may further comprise a second planarization layer disposed on the first planarization layer.

The first planarization layer may be in contact with at least a part of a side surface of the first light emitting diode.

A maximum height of the first planarization layer may be lower than a height of a top surface of the first light emitting diode.

The display device may further comprise a black matrix disposed on the second planarization layer, the first connection electrode, the second connection electrode, and/or the third connection electrode.

The display device may further comprise a black matrix disposed between the first planarization layer and the second planarization layer. The first connection electrode, the second connection electrode, and/or the third connection electrode may be disposed on the second planarization layer.

The first planarization layer may be spaced apart from the first light emitting diode. The black matrix may cover a top surface and/or a side surface of the first planarization layer.

The plurality of sub pixels may further include a second sub pixel, wherein the second sub pixel may include: a third reflection electrode and a fourth reflection electrode disposed on a driving transistor in the second sub pixel, a second light emitting diode disposed on the third reflection electrode, a third light emitting diode disposed on the fourth reflection electrode. The second light emitting diode and the third light emitting diode may emit same color light and/or may be connected in series. The second subpixel may further include: a fourth connection electrode electrically connected to the power line, a fifth connection electrode electrically connected to the driving transistor in the second sub pixel, and a sixth connection electrode electrically connected to the second light emitting diode and the third light emitting diode. The second light emitting diode may be electrically connected to the power line. The third light emitting diode may be electrically connected to the driving transistor disposed in the second sub pixel.

The display device may further comprise an adhesive layer disposed on the third reflection electrode and the fourth reflection electrode, a first planarization layer disposed on the adhesive layer, and/or a second planarization layer disposed on the first planarization layer, in the second sub pixel.

The first planarization layer may be in contact with at least a part of side surfaces of the second light emitting diode and the third light emitting diode. A maximum height of the first planarization layer may be lower than a height of a top surface of the second light emitting diode or the third light emitting diode.

The second planarization layer may be spaced apart from the second light emitting diode or the third light emitting diode. The fourth connection electrode, the fifth connection electrode, and/or the sixth connection electrode may be disposed on the second planarization layer. A black matrix may be disposed on the fourth connection electrode, the fifth connection electrode, and/or the sixth connection electrode.

The display device may further comprise a black matrix which is disposed between the first planarization layer and the second planarization layer. The black matrix maycover a top surface and a side surface of the first planarization layer. The fourth connection electrode, the fifth connection electrode, and/or the sixth connection electrode may be disposed on the second planarization layer.

In one aspect of the present disclosure, the first reflective electrode and/or the second reflective electrode may be referred to as a conductive layer..

The conductive pattern may include a conductive layer disposed on the plurality of power lines and the plurality of driving transistors. The conductive pattern may include a first planarization layer which may be disposed on the conductive layer and includes an opening which exposes at least a part of the conductive layer. The conductive pattern may include an insulating pattern which may be disposed on the conductive layer exposed by the opening.

The conductive pattern may further include a first contact electrode which electrically connects the first light emitting diode and the conductive layer. The conductive pattern may further include a second contact electrode which electrically connects the conductive layer and the driving transistor disposed in the first sub pixel. The first contact electrode and the second contact electrode may be spaced apart from each other on the insulating pattern.

Each of the first contact electrode and the second contact electrode may be in contact with the conductive layer exposed by the opening.

The conductive pattern may further include a second planarization layer disposed on the first planarization layer. The second planarization layer may be formed of the same material as the insulating pattern.

The first contact electrode and the second contact electrode may be disposed on the second planarization layer. A black matrix may be disposed on the first contact electrode and the second contact electrode.

The display device may further comprise a black matrix disposed between the first planarization layer and the second planarization layer. The first contact electrode and the second contact electrode may be disposed on the second planarization layer.

The black matrix may cover a top surface and a side surface of the first planarization layer. The plurality of connection electrodes may further include: a first contact electrode electrically connecting the first light emitting diode and the second reflection electrode; and a second contact electrode electrically connecting the second reflection electrode and the driving transistor or the power line. The first contact electrode and the second contact electrode may be spaced apart from each other on the second planarization layer formed on the exposed second reflection electrode.

The forming the plurality of connection electrodes may include: forming a first contact connection electrode electrically connecting the first light emitting diode and the second reflection electrode; and forming a second contact connection electrode electrically connecting the second reflection electrode and the driving transistor or the power line. The method may further include: spacing the first contact connection electrode and the second contact connection electrode apart from each other on the second planarization layer formed on the exposed second reflection electrode.

In the case of forming both a first planarization layer and a black matrix, the first planarization layer may be formed before forming the black matrix. The first planarization layer may be spaced apart from a placement area of the first light emitting diode and the second light emitting diode. In the case of forming both a first planarization layer and a black matrix, the black matrix may cover the top surface and the side surface of the first planarization layer.

Other detailed matters of the exemplary embodiments are included in the detailed description and the drawings.

According to the present disclosure, when any one light emitting diode is not transferred in one sub pixel, the display device may be automatically repaired during the manufacturing process without a separate repair process.

According to the present disclosure, a plurality of light emitting diodes disposed in one sub pixel is connected in series, so that the power consumption of the display device is reduced to be driven at low power.

The effects according to the present disclosure are not limited to the contents exemplified above, and more various effects are included in the present specification.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a schematic diagram of a display device according to an exemplary embodiment of the present disclosure;
FIG. 2A is a partial cross-sectional view of a display device according to an exemplary embodiment of the present disclosure;
FIG. 2B is a perspective view of a tiling display device according to an exemplary embodiment of the present disclosure;
FIG. 3 is a circuit diagram of a first sub pixel of a display device according to an exemplary embodiment of the present disclosure;
FIG. 4 is a cross-sectional view of a first sub pixel of a display device according to an exemplary embodiment of the present disclosure;
FIG. 5 is a circuit diagram of a second sub pixel of a display device according to an exemplary embodiment of the present disclosure;
FIG. 6 is a cross-sectional view of a second sub pixel of a display device according to an exemplary embodiment of the present disclosure;
FIGS. 7A to 7F are process diagrams for explaining a manufacturing method of a first sub pixel of a display device according to an exemplary embodiment of the present disclosure;
FIG. 8 is a cross-sectional view of a first sub pixel of a display device according to another exemplary embodiment of the present disclosure;
FIG. 9 is a cross-sectional view of a second sub pixel of a display device according to another exemplary embodiment of the present disclosure; and
FIGS. 10A to 10E are process diagrams for explaining a manufacturing method of a first sub pixel of a display device according to another exemplary embodiment of the present disclosure.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. The exemplary embodiments are provided by way of example so that those skilled in the art can fully understand the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly". The term "above" may refer to an overlapping relationship between respective elements.

When an element or layer is disposed "on" another element or layer, the element or layer may be interposed directly on the other element or layer, or intervening elements or layers may be present therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

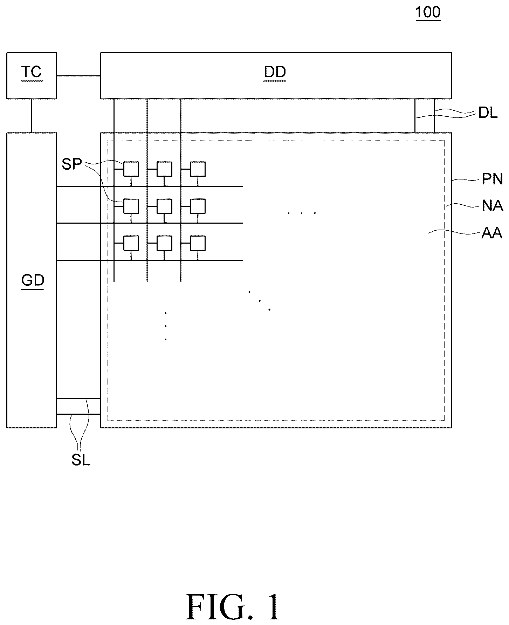

FIG. 1 is a schematic diagram of a display device according to an exemplary embodiment of the present disclosure.

In FIG. 1, for the convenience of description, among various components of the display device 100, only a display panel PN, a gate driver GD, a data driver DD, and a timing controller TC are illustrated.

Referring to FIG. 1, the display device 100 includes a display panel PN including a plurality of sub pixels SP, a gate driver GD and a data driver DD which supply various signals to the display panel PN, and a timing controller TC which controls the gate driver GD and the data driver DD.

The gate driver GD supplies a plurality of scan signals to a plurality of scan lines SL according to a plurality of gate control signals supplied from the timing controller TC. Even though in FIG. 1, it is illustrated that one gate driver GD is disposed to be spaced apart from one side of the display panel PN, the number of the gate drivers GD and the placement thereof are not limited thereto.

The data driver DD converts image data input from the timing controller TC into a data voltage using a reference gamma voltage in accordance with a plurality of data control signals supplied from the timing controller TC. The data driver DD may supply the converted data voltage to the plurality of data lines DL.

The timing controller TC aligns image data input from the outside to supply the image data to the data driver DD. The timing controller TC may generate a gate control signal and a data control signal using synchronization signals input from the outside, such as a dot clock signal, a data enable signal, and horizontal/vertical synchronization signals. The timing controller TC supplies the generated gate control signal and data control signal to the gate driver GD and the data driver DD, respectively, to control the gate driver GD and the data driver DD.

The display panel PN is a configuration which displays images to the user and includes the plurality of sub pixels SP. In the display panel PN, the plurality of scan lines SL and the plurality of data lines DL intersect each other and the plurality of sub pixels SP is connected to the scan lines SL and the data lines DL, respectively. In addition, even though it is not illustrated in the drawing, each of the plurality of sub pixels SP may be connected to a high potential power line (e.g. a high potential voltage line VL1), a low potential power line (e.g. a low potential voltage line VL2), and a reference line (e.g. a reference voltage line VL3).

In the display panel PN, an active area AA and a non-active area NA enclosing the active area AA may be defined.

The active area AA is an area in which images are displayed in the display device 100. In the active area AA, a plurality of sub pixels SP which configures a plurality of pixels PX and a circuit for driving the plurality of sub pixels SP may be disposed. The plurality of sub pixels SP is a minimum unit which configures the active area AA and n sub pixels SP may form one pixel PX. In each of the plurality of sub pixels SP, a light emitting element (e.g. LED) and a thin film transistor for driving the light emitting element may be disposed. The plurality of light emitting elements may be defined in different ways depending on the type of the display panel PN. For example, when the display panel PN is an inorganic light emitting display panel PN, the light emitting element may be a light emitting diode LED or a micro light emitting diode micro LED.

In the active area AA, a plurality of signal lines which transmits various signals to the plurality of sub pixels SP is disposed. For example, the plurality of signal lines may include a plurality of data lines DL which supplies a data voltage to each of the plurality of sub pixels SP and a plurality of scan lines which supplies a gate voltage to each of the plurality of sub pixels SP. The plurality of scan lines SL extends to one direction in the active area AA to be connected to the plurality of sub pixels SP and the plurality of data lines DL extends to a direction different from the one direction in the active area AA to be connected to the plurality of sub pixels SP. In addition, in the active area AA, a low potential power line (e.g. a low potential voltage line VL2) and a high potential power line (e.g. a high potential voltage line VL1 may be further disposed, but are not limited thereto.

The non-active area NA is an area where images are not displayed so that the non-active area NA may be defined as an area extending from the active area AA. In the non-active area NA, a link line which transmits a signal to the sub pixel SP of the active area AA, a pad electrode, or a driving IC, such as a gate driver IC or a data driver IC, may be disposed.

The non-active area NA may be located on a rear surface of the display panel PN, that is, a surface on which the sub pixels SP are not disposed or may be omitted, and is not limited as illustrated in the drawing.

A driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner. For example, the data driver DD and the timing controller TC are formed in separate flexible film and printed circuit board and may be electrically connected to the display panel PN by bonding the flexible film and the printed circuit board to a pad electrode formed in the non-active area NA of the display panel PN. If the gate driver GD is mounted in the GIP manner and the data driver DD and the timing controller TC transmit a signal to the display panel PN through a pad electrode of the non-active area NA, an area of the non-active area NA to dispose the gate driver GD and the pad electrode needs to be ensured. By doing this, a bezel may be increased.

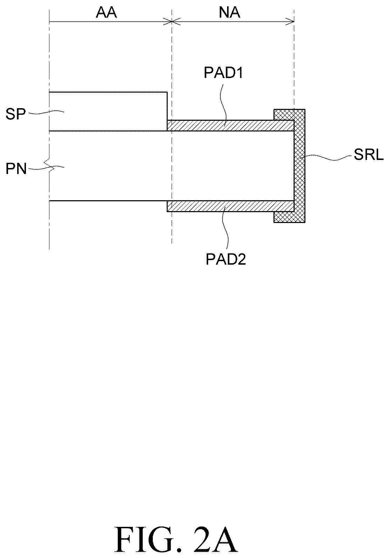

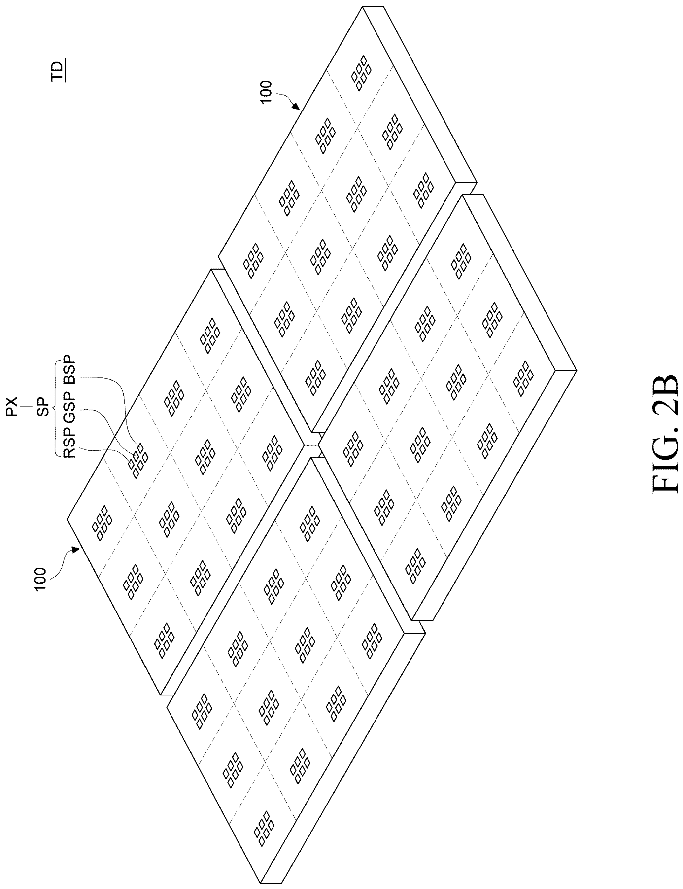

In contrast, when the gate driver GD is mounted in the active area AA in the GIA manner and a side line SRL which connects the signal line on the front surface of the display panel PN to the pad electrode on a rear surface of the display panel PN is formed to bond the flexible film and the printed circuit board onto a rear surface of the display panel PN, the non-active area NA may be minimized on the front surface of the display panel PN. That is, when the gate driver GD, the data driver DD, and the timing controller TC are connected to the display panel PN as described above, a zero bezel in which there is no bezel may be substantially implemented, which will be described in more detail with reference to FIGS. 2A and 2B.

FIG. 2A is a partial cross-sectional view of a display device according to an exemplary embodiment of the present disclosure and FIG. 2B is a perspective view of a tiling display device according to an exemplary embodiment of the present disclosure.

First, referring to FIG. 2A, in the non-active area NA of the display panel PN, a plurality of pad electrodes for transmitting various signals to the plurality of sub pixels SP is disposed. For example, in a non-active area NA on the front surface of the display panel PN, a first pad electrode PAD1 which transmits a signal to the plurality of sub pixels SP is disposed. In a non-active area NA on the rear surface of the display panel PN, a second pad electrode PAD2 which is electrically connected to a driving component, such as a flexible film and the printed circuit board, is disposed.

In this case, even though it is not illustrated in the drawing, various signal lines connected to the plurality of sub pixels SP, for example, a scan line SL or a data line DL extend from the active area AA to the non-active area NA to be electrically connected to the first pad electrode PAD1.

The side line SRL is disposed along a side surface of the display panel PN. The side line SRL may electrically connect the first pad electrode PAD1 on the front surface of the display panel PN and the second pad electrode PAD2 on the rear surface of the display panel PN. Therefore, a signal from a driving component on the rear surface of the display panel PN may be transmitted to the plurality of sub pixels SP through the second pad electrode PAD2, the side line SRL, and the first pad electrode PAD1. Accordingly, a signal transmitting path is formed from the front surface of the display panel PN to the side surface and the rear surface to minimize an area of the non-active area NA of the display panel PN.

Referring to FIG. 2B, a tiling display device TD having a large screen size may be implemented by connecting a plurality of display devices 100. At this time, as illustrated in FIG. 2A, when the tiling display device TD is implemented using a display device 100 with a minimized bezel, a seam area in which an image between the display devices 100 is not displayed is minimized so that a display quality may be improved.

For example, the plurality of sub pixels SP may form one pixel PX and a distance D1 between an outermost pixel PX of one display device 100 and an outermost pixel PX of another display device 100 adjacent to one display device may be implemented to be equal to a distance D1 between pixels PX in one display device 100. Accordingly, the distance of the pixels PX between the display devices 100 is constantly configured to minimize the seam area.

However, FIGS. 2A and 2B are illustrative so that the display device 100 according to the exemplary embodiment of the present disclosure may be a general display device 100 with a bezel, but is not limited thereto.

The plurality of sub pixels SP may be configured by sub pixels SP for emitting different color light. For example, as illustrated in FIG. 2B, the plurality of sub pixels SP may include a red sub pixel RSP, a green sub pixel GSP, and a blue sub pixel BSP. However, it is not limited thereto and the plurality of sub pixels SP may further include a sub pixel SP which emits different color light.

At least some of the plurality of sub pixels SP may include two light emitting diodes, respectively. At this time, two light emitting didoes may emit same color light. For example, in the red sub pixel RSP, two light emitting diodes which emit red light may be disposed, in the green sub pixel GSP, two light emitting diodes which emit green light may be disposed, and in the blue sub pixel BSP, two light emitting diodes which emit blue light may be disposed.

The plurality of sub pixels SP may include a light emitting diode, such as a light-emitting diode LED or a micro light-emitting diode micro LED. The light emitting diode is mainly transferred onto the display device using a transfer method and in this case, the light emitting diode may be not transferred or even though the light emitting diode is transferred, the light emitting diode may be missing during the manufacturing process. In the display device 100 according to an exemplary embodiment of the present disclosure, among the plurality of sub pixels SP, a sub pixel SP in which one light emitting diode is not transferred or missing is defined as a first sub pixel SP1. Further, a sub pixel SP in which two light emitting diodes are normally transferred is defined as a second sub pixel SP2. Hereinafter, the first sub pixel SP1 and the second sub pixel SP2 will be described in more detail.

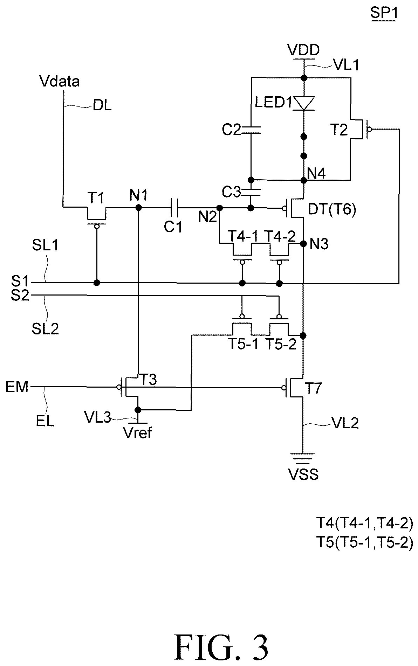

FIG. 3 is a circuit diagram of a first sub pixel of a display device according to an exemplary embodiment of the present disclosure. Specifically, FIG. 3 is a circuit diagram of a pixel circuit of a first sub pixel SP1 of a display device 100 according to an exemplary embodiment of the present disclosure.

Referring to FIG. 3, the first sub pixel SP1 may be connected to a first scan line SL1, a second scan line SL2, a data line DL, an emission line EL, a high potential voltage line VL1, a low potential voltage line VL2, and a reference voltage line VL3. In the first sub pixel SP1, a pixel circuit including a first transistor T1, a second transistor T2, a third transistor T3, a fourth transistor T4, a fifth transistor T5, a sixth transistor T6, a seventh transistor T7, a first capacitor C1, a second capacitor C2, and a third capacitor C3 and a first light emitting diode LED1 connected to the pixel circuit may be disposed. In this case, the high potential voltage line VL1 may be referred to as a first power line, the low potential voltage line VL2 may be referred to as a second power line, and the reference voltage line VL3 may be referred to as a third power line.

First, the pixel circuit of the first sub pixel SP1 may include the first transistor T1, the second transistor T2, the third transistor T3, the fourth transistor T4, the fifth transistor T5, the sixth transistor T6, and the seventh transistor T7. Each of the first transistor T1, the second transistor T2, the third transistor T3, the fourth transistor T4, the fifth transistor T5, the sixth transistor T6, and the seventh transistor T7 may include a gate electrode, a source electrode, and a drain electrode.

The first transistor T1, the second transistor T2, the third transistor T3, the fourth transistor T4, the fifth transistor T5, the sixth transistor T6, and the seventh transistor T7 may be N-type transistors or P-type transistors. In the N-type transistor, carriers are electrons so that electrons may flow from the source electrode to the drain electrode and currents may flow from the drain electrode to the source electrode. In the P-type transistor, carriers are holes so that holes may flow from the source electrode to the drain electrode and currents may flow from the source electrode to the drain electrode. For example, one of the plurality of transistors may be an N-type transistor and the other one of the plurality of transistors may be a P-type transistor. Hereinafter, the description will be made under the assumption that the first transistor T1, the second transistor T2, the third transistor T3, the fourth transistor T4, the fifth transistor T5, the sixth transistor T6, and the seventh transistor T7 are P-type transistors, but the present disclosure is not limited thereto.

The first transistor T1 may include a first gate electrode, a first source electrode, and a first drain electrode. The first gate electrode may be connected to the first scan line SL1, the first source electrode may be connected to the data line DL, and the first drain electrode may be connected to the first node N1. The first transistor T1 may transmit a data voltage Vdata from the data line DL to the first node N1 based on a first scan signal S1 of the first scan line SL1.

The third transistor T3 may include a third gate electrode, a third source electrode, and a third drain electrode. The third gate electrode may be connected to the emission line EL, the third source electrode may be connected to the reference voltage line VL3, and the third drain electrode may be connected to the first node N1. The third transistor T3 may transmit a reference voltage Vref from the reference voltage line VL3 to the first node N1 according to the emission signal EM and may allow the second node N2 and the third node N3 to maintain a constant voltage while the first light emitting diode LED1 emits light. The third transistor T3 may be referred to as a first emission transistor.

The fourth transistor T4 may include a fourth gate electrode, a fourth source electrode, and a fourth drain electrode. The fourth gate electrode may be connected to the first scan line SL1, the fourth source electrode may be connected to the second node N2, and the fourth drain electrode may be connected to the third node N3. The fourth transistor T4 may short a sixth gate electrode and a sixth drain electrode of the sixth transistor T6 and diode-connect the sixth transistor T6. In the diode connection, the gate electrode and the drain electrode are shorted so that the transistor operates as a diode.

The fourth transistor T4 may be implemented with a structure in which two transistors are connected in series. The fourth transistor T4 may include a 4-1-th transistor T4-1 and a 4-2-th transistor T4-2. A gate electrode of the 4-1-th transistor T4-1 and a gate electrode of the 4-2-th transistor T4-2 may be connected to the first scan line SL1 and a drain electrode or a source electrode of the 4-1-th transistor T4-1 may be connected to a source electrode or a drain electrode of the 4-2-th transistor T4-2. As the fourth transistor T4 is implemented by two transistors which are connected in series, the reliability is enhanced and the current leakage from the sixth gate electrode of the sixth transistor T6 may be minimized.

The fifth transistor T5 may include a fifth gate electrode, a fifth source electrode, and a fifth drain electrode. The fifth gate electrode may be connected to the second scan line SL2, the fifth source electrode may be connected to the reference voltage line VL3, and the fifth drain electrode may be connected to the third node N3. The fifth transistor T5 may supply the reference voltage Vref to the third node N3 based on a second scan signal S2 of the second scan line SL2 and reset the sixth drain electrode of the sixth transistor T6 which is the third node N3 to reference voltage Vref.

The fifth transistor T5 may be implemented with a structure in which two transistors are connected in series. The fifth transistor T5 may include a 5-1-th transistor T5-1 and a 5-2-th transistor T5-2. A gate electrode of the 5-1-th transistor T5-1 and a gate electrode of the 5-2-th transistor T5-2 may be connected to the second scan line SL2 and a drain electrode or a source electrode of the 5-1-th transistor T5-1 may be connected to a source electrode or a drain electrode of the 5-2-th transistor T5-2. As the fifth transistor T5 is implemented by two transistors which are connected in series, the reliability is enhanced and the current leakage from the sixth gate electrode of the sixth transistor T6 may be minimized.

The sixth transistor T6 may include a sixth gate electrode, a sixth source electrode, and a sixth drain electrode. The sixth gate electrode may be connected to the second node N2, the sixth source electrode may be connected to the fourth node N4, and the sixth drain electrode may be connected to the third node N3. The sixth transistor T6 is turned on to control a driving current which flows in the first light emitting diode LED1 and may be referred to as a driving transistor DT.

The second transistor T2 may include a second gate electrode, a second source electrode, and a second drain electrode. The second gate electrode may be connected to the first scan line SL1, the second source electrode may be connected to the high potential voltage line VL1, and the second drain electrode may be connected to the fourth node N4. The second transistor T2 may transmit a high potential power voltage VDD to the fourth node N4 based on a first scan signal S1 of the first scan line SL1.

The seventh transistor T7 may include a seventh gate electrode, a seventh source electrode, and a seventh drain electrode. The seventh gate electrode may be connected to the emission line EL, the seventh source electrode may be connected to the third node N3, and the seventh drain electrode may be connected to the low potential voltage line VL2. The seventh transistor T7 may supply a low potential power voltage VSS to the third node N3 based on the emission signal EM to flow a driving current. The seventh transistor T7 may be referred to as a second emission transistor.

The first transistor T1, the second transistor T2, the fourth transistor T4, and the fifth transistor T5 which are controlled by the first scan signal S1 or the second scan signal S2 may be referred to as scan transistors.

The first capacitor C1 may include a capacitor electrode connected to the first node N1 and a capacitor electrode connected to the second node N2. The first capacitor C1 fixes a voltage applied to the sixth gate electrode of the sixth transistor T6 while the first light emitting diode LED1 emits light, to maintain a constant driving current.

The second capacitor C2 may include a capacitor electrode connected to the fourth node N4 and a capacitor electrode connected to the high potential voltage line VL1. That is, the second capacitor C2 may include capacitor electrodes connected to the cathode and the anode of the first light emitting diode LED1. The second capacitor C2 allows the first light emitting diode LED1 to emit light while maintaining the same luminance, while maintaining the constant voltage of the first light emitting diode LED1 to flow the same driving current.

The third capacitor C3 may include a capacitor electrode connected to the second node N2 and a capacitor electrode connected to the fourth node N4. In other words, the third capacitor C3 may be a capacitor formed between the sixth gate electrode and the sixth source electrode of the sixth transistor T6 and between the sixth gate electrode and the cathode of the first light emitting diode LED1. Accordingly, the third capacitor C3 may maintain a gate-source voltage of the sixth transistor T6.

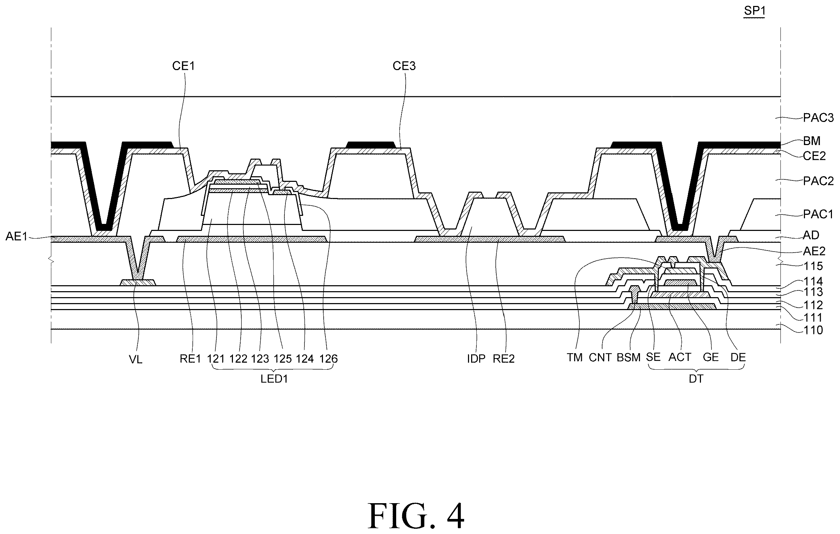

As described above, the first sub pixel SP1 is a sub pixel SP in which a light emitting diode is not transferred or missing, among the plurality of sub pixels SP. However, as illustrated in FIG. 3, a place where a light emitting diode other than the first light emitting diode LED1 needs to be disposed is not open, but is connected so that the first light emitting diode LED1 may normally emit light. Hereinafter, a cross-sectional structure of the first sub pixel SP1 will be described in detail with reference to FIG. 4.

FIG. 4 is a cross-sectional view of a first sub pixel of a display device according to an exemplary embodiment of the present disclosure. It is assumed that in the first sub pixel SP1 of FIG. 4, the first light emitting diode LED1 is normally transferred onto a first reflection electrode RE1, but a light emitting diode which needs to be disposed is not transferred onto or missing from the second reflection electrode RE2.

Referring to FIG. 4, the substrate 110 may be a substrate which supports components disposed thereabove and may be an insulating substrate. For example, the substrate 110 may be formed of glass or resin. Further, the substrate 110 may include polymer or plastic. In some exemplary embodiments, the substrate 110 may be formed of a plastic material having flexibility. A plurality of pixels is formed on the substrate 110 to display images.

A light shielding layer BSM may be disposed on the substrate 110. The light shielding layer BSM blocks light which is incident to active layers ACT of the plurality of transistors to minimize a leakage current. For example, the light shielding layer BSM is disposed below the active layer ACT of the driving transistor DT to block light incident onto the active layer ACT. If light is irradiated onto the active layer ACT, a leakage current is generated, which deteriorates the reliability of the transistor. Accordingly, the light shielding layer BSM which blocks the light is disposed on the substrate 110 to improve the reliability of the driving transistor DT. The light shielding layer BSM may be configured by an opaque conductive material such as copper (Cu), aluminum (Al), molybdenum (Mo), nickel (Ni), titanium (Ti), chrome (Cr), or an alloy thereof, but is not limited thereto.

A buffer layer 111 may be disposed on the light shielding layer BSM. The buffer layer 111 may reduce permeation of moisture or impurities through the substrate 110. The buffer layer 111 may be configured by a single layer or a double layer of silicon oxide (SiOx) or silicon nitride (SiNx), but is not limited thereto. However, the buffer layer 111 may be omitted depending on a type of substrate 110 or a type of transistor, but is not limited thereto.

A driving transistor DT including an active layer ACT, a gate electrode GE, a source electrode SE, and a drain electrode DE is disposed on the buffer layer 111.

Even though it is not illustrated in FIG. 4, an additional buffer layer may be disposed between the substrate 110 and the light shielding layer BSM. The additional buffer layer may be configured by, for example, a single layer or a double layer of silicon oxide (SiOx) or silicon nitride (SiNx) to reduce permeation of moisture or impurities through the substrate 110, like the above-described buffer layer 111.

First, the active layer ACT of the driving transistor DT may be disposed on the buffer layer 111. The active layer ACT may be formed of a semiconductor material, such as an oxide semiconductor, amorphous silicon, or polysilicon, but is not limited thereto. Further, even though it is not illustrated in the drawings, other transistors, such as a switching transistor, a sensing transistor, and an emission control transistor, other than the driving transistor DT, may be further disposed. The active layers of the transistors may also be formed of a semiconductor material, such as an oxide semiconductor, amorphous silicon, or polysilicon, but are not limited thereto. The active layer of the transistor included in the pixel circuit, such as the driving transistor DT, the switching transistor, the sensing transistor, and the emission control transistor, may be formed of the same material, or formed of different materials.

A gate insulating layer 112 may be disposed on the active layer ACT. The gate insulating layer 112 is an insulating layer which electrically insulates the active layer ACT from the gate electrode GE and may be configured by a single layer or a double layer of silicon oxide (SiOx) or silicon nitride (SiNx), but is not limited thereto.

The gate electrode GE may be disposed on the gate insulating layer 112. The gate electrode GE may be configured by a conductive material, such as copper (Cu), aluminum (Al), molybdenum (Mo), nickel (Ni), titanium (Ti), chrome (Cr), or an alloy thereof, but is not limited thereto.

Further, an intermediate electrode CNT may be disposed on the gate insulating layer 112. The intermediate electrode CNT may be formed of the same material as the gate electrode GE and may be electrically connected to the light shielding layer BSM.

A first interlayer insulating layer 113 may be disposed on the gate electrode GE. In the first interlayer insulating layer 113, a contact hole through which each of the source electrode SE and the drain electrode DE is connected to the active layer ACT may be formed. The first interlayer insulating layer 113 is an insulating layer which protects components below the first interlayer insulating layer 113 and may be configured by a single layer or a double layer of silicon oxide (SiOx) or silicon nitride (SiNx), but is not limited thereto.

A conductive layer TM may be disposed on the first interlayer insulating layer 113. The conductive layer TM may be disposed on the gate electrode GE. The conductive layer TM may also configure the storage capacitor together with the gate electrode GE. However, the conductive layer TM may be omitted depending on the exemplary embodiment.

A second interlayer insulating layer 114 may be disposed on the conductive layer TM. In the second interlayer insulating layer 114, a contact hole through which each of the source electrode SE and the drain electrode DE is connected to the active layer ACT may be formed. The second interlayer insulating layer 114 is an insulating layer which protects components below the second interlayer insulating layer 114 and may be configured by a single layer or a double layer of silicon oxide (SiOx) or silicon nitride (SiNx), but is not limited thereto.

The source electrode SE and the drain electrode DE which are electrically connected to the active layer ACT may be disposed on the second interlayer insulating layer 114. The drain electrode DE may be electrically connected to the second reflection electrode RE2 through a second additional electrode AE2 and a second connection electrode CE2. The source electrode SE and the drain electrode DE may be configured by a conductive material, such as copper (Cu), aluminum (Al), molybdenum (Mo), nickel (Ni), titanium (Ti), chrome (Cr), or an alloy thereof, but are not limited thereto.

The power line VL is disposed on the second interlayer insulting layer 114. Specifically, the power line VL is disposed on the second interlayer insulating layer 114 and spaced apart from the source electrode SE and the drain electrode DE, and may be formed of the same material as a source electrode (SE) material and a drain electrode (DE) material, but is not limited thereto. The power line VL may be a low potential power line and in this case, a low potential voltage may be supplied to the power line VL. However, the present disclosure is not limited thereto and the power line VL may be a high potential power line.

The power line VL may be electrically connected to the first additional electrode AE1 and the first connection electrode CE1. Therefore, the high potential voltage line VL1 may be connected to the second electrode 125 of the first light emitting diode LED1 through the first additional electrode AE1 and the first connection electrode CE1. Therefore, the power line VL may transmit a high potential voltage to the first additional electrode AE1, the first connection electrode CE1, and the second electrode 125 of the first light emitting diode LED1.

An overcoating layer 115 may be disposed on the source electrode SE, the drain electrode DE, and the power line VL. The overcoating layer 115 may be disposed so as to cover the source electrode SE, the drain electrode DE, and the power line VL. By doing this, the overcoating layer 115 may planarize top surfaces of configurations disposed therebelow, such as the source electrode SE, the drain electrode DE, and the power line VL. Further, the overcoating layer 115 may include one or more contact holes. The overcoating layer 115 may be configured, for example, by benzocyclobutene or an acrylic organic material, but is not limited thereto.

The first reflection electrode RE1 and the second reflection electrode RE2 are disposed on the overcoating layer 115. The first reflection electrode RE1 is disposed below the first light emitting diode LED1 to reflect light emitted from the first light emitting diode LED1 to an upper portion of the substrate 110. The second reflection electrode RE2 may be electrically connected to the first light emitting diode LED1 through the third connection electrode CE3. Further, the second reflection electrode RE2 may be electrically connected to the driving transistor DT through the second connection electrode CE2. The first reflection electrode RE1 and the second reflection electrode RE2 may include various conductive layers by considering a light reflection efficiency and resistance together. For example, the first reflection electrode RE1 and the second reflection electrode RE2 may use an opaque conductive layer, such as silver (Ag), aluminum (Al), molybdenum (Mo), titanium (Ti), or an alloy thereof, and a transparent conductive layer, such as indium tin oxide together, but are not limited thereto.

The first additional electrode AE1 and the second additional electrode AE2 may be disposed on the overcoating layer 115. The first additional electrode AE1 and the second additional electrode AE2 may be disposed on the same layer as the first reflection electrode RE1 and the second reflection electrode RE2. Further, the first additional electrode AE1 and the second additional electrode AE2 may be formed of the same material as the first reflection electrode RE1 and the second reflection electrode RE2, but are not limited thereto.

The first additional electrode AE1 may be connected to the power line VL through the contact hole of the overcoating layer 115. Further, the first additional electrode AE1 may be electrically connected to the first light emitting diode LED1 through the first connection electrode CE1.

The second additional electrode AE2 may be connected to the drain electrode DE of the driving transistor DT through the contact hole of the overcoating layer 115. The second additional electrode AE2 may be electrically connected to the second reflection electrode RE2 through the second connection electrode CE2.

An adhesive layer AD may be disposed on the first reflection electrode RE1 and the second reflection electrode RE2. The adhesive layer AD may be disposed between one of the first reflection electrode RE1 and the second reflection electrode RE2 and the first light emitting diode LED1. Referring to FIG. 4, in the first sub pixel SP1, the first light emitting diode LED1 is transferred onto the first reflection electrode RE1 so that the adhesive layer AD may be disposed between the first reflection electrode RE1 and the first light emitting diode LED1. Therefore, the first light emitting diode LED1 may be fixed onto the first reflection electrode RE1. Therefore, the adhesive layer AD may include a protrusion in an area overlapping the first light emitting diode LED1. Therefore, the adhesive layer AD may include a step in the area overlapping the first reflection electrode RE1.

The adhesive layer AD may include an opening which exposes the second reflection electrode RE2. As described above, a part of the top surface of the second reflection electrode RE2 may be exposed through the opening of the adhesive layer AD. Further, the adhesive layer AD may further include an opening which exposes at least a part of each of the first additional electrode AE1 and the second additional electrode AE2.

For example, the adhesive layer AD may be selected from any one of adhesive polymer, epoxy resist, UV resin, polyimide, acrylate, urethane, and polydimethylsiloxane (PDMS), but is not limited thereto.

The first light emitting diode LED1 is disposed on the first reflection electrode RE1. The first light emitting diode LED1 may include a first semiconductor layer 121, an emission layer 122, a second semiconductor layer 123, a first electrode 124, a second electrode 125, and an encapsulation film 126.

The first semiconductor layer 121 may be disposed on the adhesive layer AD and the second semiconductor layer 123 may be disposed on the first semiconductor layer 121. The first semiconductor layer 121 and the second semiconductor layer 123 may be layers formed by doping n-type or p-type impurities into a specific material. For example, the first semiconductor layer 121 and the second semiconductor layer 123 may be layers doped with n-type or p-type impurities into a material such as gallium nitride (GaN), indium aluminum phosphide (InAlP), or gallium arsenide (GaAs). The p-type impurity may be magnesium (Mg), zinc (Zn), and beryllium (Be), and the n-type impurity may be silicon (Si), germanium (Ge), and tin (Sn), but is not limited thereto.

The emission layer 122 may be disposed between the first semiconductor layer 121 and the second semiconductor layer 123. The emission layer 122 is supplied with holes and electrons from the first semiconductor layer 121 and the second semiconductor layer 123 to emit light. The emission layer 122 may be formed by a single layer or a multi-quantum well (MQW) structure, and for example, may be formed of indium gallium nitride (InGaN) or gallium nitride (GaN), but is not limited thereto.

The first electrode 124 may be disposed on the first semiconductor layer 121. The first electrode 124 may be an electrode which electrically connects the driving transistor DT and the first semiconductor layer 121. The first electrode 124 may be disposed on a top surface of the first semiconductor layer 121 which is exposed from the emission layer 122 and the second semiconductor layer 123.

The first electrode 124 may be electrically connected to the second reflection electrode RE2 through the third connection electrode CE3.

The first electrode 124 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

The second electrode 125 may be disposed on the second semiconductor layer 123. The second electrode 125 may be disposed on the top surface of the second semiconductor layer 123. The second electrode 125 may be an electrode which electrically connects the power line VL and the second semiconductor layer 123. The second electrode 125 may be electrically connected to the power line VL through the first connection electrode CE1.

The second electrode 125 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

Next, the encapsulation film 126 which encloses the first semiconductor layer 121, the emission layer 122, the second semiconductor layer 123, the first electrode 124, and the second electrode 125 may be disposed. The encapsulation film 126 is formed of an insulating material to protect the first semiconductor layer 121, the emission layer 122, and the second semiconductor layer 123. In the encapsulation film 126, a contact hole which exposes the first electrode 124 and the second electrode 125 is formed to electrically connect the first electrode 124 and the third connection electrode CE3. The second electrode 125 and the first connection electrode CE1 may be electrically connected.

A part of the side surface of the first semiconductor layer 121 may be exposed from the encapsulation film 126. The first light emitting diode LED1 manufactured on a wafer is separated from the wafer to be transferred onto the display panel PN. However, during the process of separating the first light emitting diode LED1 from the wafer, a part of the encapsulation film 126 may be torn. For example, a part of the encapsulation film 126 which is adjacent to a lower edge of the first semiconductor layer 121 of the first light emitting diode LED1 is torn during the process of separating the first light emitting diode LED1 from the wafer. Accordingly, a lower portion of the side surface of the first semiconductor layer 121 may be exposed to the outside. However, even though the lower portion of the first light emitting diode LED1 is exposed from the encapsulation film 126, the first connection electrode CE1 and the third connection electrode CE3 are formed after forming the first planarization layer PAC1 and the second planarization layer PAC2 which cover the side surface of the first semiconductor layer 121. Accordingly, a short defect may be reduced.

In the first sub pixel SP1, the first planarization layer PAC1 may be disposed on the first reflection electrode RE1 and the second reflection electrode RE2. The first planarization layer PAC1 may be disposed so as to enclose a side surface of the first light emitting diode LED1. Specifically, the first planarization layer PAC1 may be in contact with at least a part of a side surface of the first light emitting diode LED1. Therefore, the first planarization layer PAC1 may fix and protect the first light emitting diode LED1.

A maximum height of the first planarization layer PAC1 may be smaller than a maximum height of the first light emitting diode LED1. A maximum height of the first planarization layer PAC1 may be lower than a top surface of the second electrode 125 of the first light emitting diode LED1. The more adjacent to the first light emitting diode LED1, the larger the height of the first planarization layer PAC1.

The first planarization layer PAC1 may not overlap a top surface of the first light emitting diode LED1. For example, the first planarization layer PAC1 may not overlap top surfaces of the first electrode 124 and the second electrode 125 of the first light emitting diode LED1.

The first planarization layer PAC1 may include an opening which exposes a part of the top surface of the second reflection electrode RE2. The opening of the first planarization layer PAC1 may be formed so as to overlap the opening of the adhesive layer AD. In other words, the opening of the first planarization layer PAC1 may be connected to the opening of the adhesive layer AD. Therefore, the part of the top surface of the second reflection electrode RE2 may be exposed through the openings of the adhesive layer AD and the first planarization layer PAC1.

The first planarization layer PAC1 may further include an opening which exposes the first additional electrode AE1 and the second additional electrode AE2. At this time, the opening of the first planarization layer PAC1 may be formed so as to overlap the opening of the adhesive layer AD and may be connected from the opening of the adhesive layer. Therefore, a part of the top surfaces of the first additional electrode AE1 and the second additional electrode AE2 may be exposed through the openings of the first planarization layer PAC1 and the adhesive layer AD.

For example, the first planarization layer PAC1 may be configured by benzocyclobutene or an acrylic organic material, but is not limited thereto.

A second planarization layer PAC2 may be disposed on the first planarization layer PAC1. The second planarization layer PAC2 may be spaced apart from the first light emitting diode LED1 on the first planarization layer PAC1. Therefore, the second planarization layer PAC2 may expose a part of the top surface of the first planarization layer PAC1 which is adjacent to the first light emitting diode LED1.

The second planarization layer PAC2 may also be disposed on a part of the top surface of the first light emitting diode LED1. For example, the second planarization layer PAC2 may be disposed between the first electrode 124 and the second electrode 125 on the first light emitting diode LED1. However, the second planarization layer PAC2 may not overlap the first electrode 124 and the second electrode 125 of the first light emitting diode LED1.

The second planarization layer PAC2 may cover a part of a side surface of the first planarization layer PAC1. For example, the second planarization layer PAC2 may be filled in the openings of the first planarization layer PAC1 and the adhesive layer AD which expose the first additional electrode AE1 and the second additional electrode AE2. Further, the second planarization layer PAC2 may include contact holes to connect the first electrode 124 and the second electrode 125 and the first additional electrode AE1 and the second additional electrode AE2 to each other. For example, the contact holes may be used to connect the first electrode 124 and the second additional electrode AE2 to each other and connect the second electrode 125 and the first additional electrode AE1 to each other.

The second planarization layer PAC2 may include an opening which exposes a part of the top surface of the second reflection electrode RE2. The opening of the second planarization layer PAC2 may be connected from the openings of the first planarization layer PAC1 and the adhesive layer AD. Therefore, the part of the top surface of the second reflection electrode RE2 may be exposed through the openings of the second planarization layer PAC2, the first planarization layer PAC1, and the adhesive layer AD.

An insulating pattern IDP may be disposed on the second reflection electrode RE2 exposed through the openings of the first planarization layer PAC1, the second planarization layer PAC2, and the adhesive layer AD.

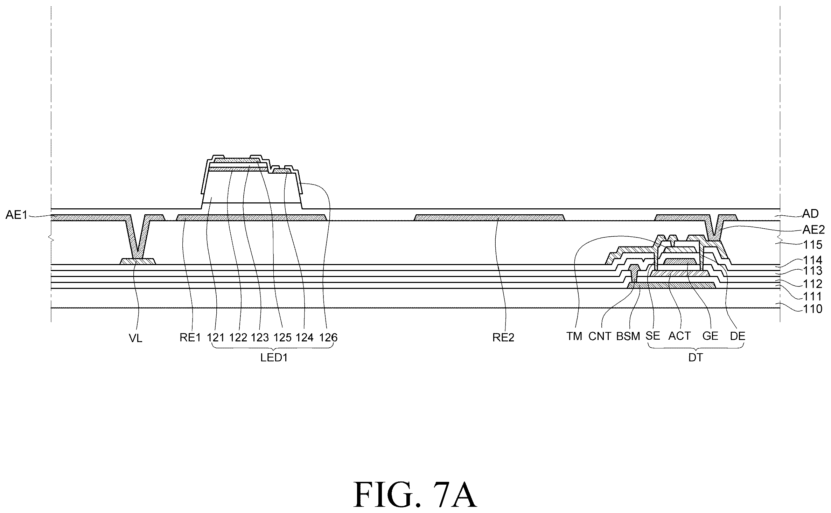

The insulating pattern IDP may be spaced apart from the first planarization layer PAC1 and the second planarization layer PAC2. The width of the insulating pattern IDP may be reduced toward the upper portion, but is not limited thereto. The insulating pattern IDP may be formed in the same process step as the second planarization layer PAC2. Therefore, the insulating pattern IDP may be formed of the same material as the second planarization layer PAC2, but is not limited thereto. A manufacturing process of the insulating pattern IDP will be described in detail with reference to FIGS. 7A to 7F.

A height of the top surface of the insulating pattern IDP may be lower than a height of the top surface of the second planarization layer PAC2. For example, the first planarization layer PAC1 is disposed below the second planarization layer PAC2 so that a height of the top surface of the second planarization layer PAC2 may be high. In contrast, the first planarization layer PAC1 may not be disposed on the second reflection electrode RE2 on which the insulating pattern IDP is disposed. Therefore, when the insulating pattern IDP is formed by the same process as the second planarization layer PAC2, heights of top surfaces of the insulating pattern IDP and the second planarization layer PAC2 may be different from each other depending on whether the first planarization layer PAC1 which may be disposed below the second planarization layer PAC2 is disposed.

The first connection electrode CE1, the second connection electrode CE2, and the third connection electrode CE3 are disposed on the second planarization layer PAC2 and the insulating pattern IDP.

The first connection electrode CE1 electrically connects the power line VL and the first light emitting diode LED1. Specifically, the first connection electrode CE1 may be connected to the first additional electrode AE1 which is connected to the power line VL through a contact hole of the second planarization layer PAC2. Further, the first connection electrode CE1 may be connected to the second electrode 125 of the first light emitting diode LED1.

The third connection electrode CE3 electrically connects the first light emitting diode LED1 and the second reflection electrode RE2. Specifically, the third connection electrode CE3 may electrically connect the first electrode 124 of the first light emitting diode LED1 and the second reflection electrode RE2.

The third connection electrode CE3 may be in contact with the top surface of the second reflection electrode RE2 which is exposed in the vicinity of the insulating pattern IDP. For example, the third connection electrode CE3 extends along the side surfaces of the adhesive layer AD, the first planarization layer PAC1, and the second planarization layer PAC2 adjacent to the insulating pattern IDP to be in contact with the exposed top surface of the second reflection electrode RE2. The third connection electrode CE3 may extend to the top surface of the insulating pattern IDP along the side surface of the insulating pattern IDP.

The first connection electrode CE1 and the third connection electrode CE3 may be spaced apart from each other on the second planarization layer PAC2 overlapping the first light emitting diode LED1.

The second connection electrode CE2 electrically connects the second reflection electrode RE2 and the driving transistor DT. Even though in FIG. 4, it is illustrated that the second connection electrode CE2 electrically connects the second reflection electrode RE2 and the drain electrode DE of the driving transistor DT, but is not limited thereto. For example, the second connection electrode CE2 may electrically connect the second reflection electrode RE2 and the source electrode SE of the driving transistor DT.

The second connection electrode CE2 may be in contact with the top surface of the second additional electrode AE2 connected to the driving transistor DT through the contact hole of the second planarization layer PAC2.

The second connection electrode CE2 extends along the side surfaces of the adhesive layer AD, the first planarization layer PAC1, and the second planarization layer PAC2 adjacent to the insulating pattern IDP to be in contact with the exposed top surface of the second reflection electrode RE2. The second connection electrode CE2 may extend to the top surface of the insulating pattern IDP along the side surface of the insulating pattern IDP.

The second connection electrode CE2 and the third connection electrode CE3 may be spaced apart from each other on the insulating pattern IDP.

As described above, in FIG. 4, for the convenience of description, an example that the first light emitting diode LED1 is disposed on the first reflection electrode RE1 has been described. However, the present disclosure is not limited thereto and the first light emitting diode LED1 may be disposed on the second reflection electrode RE2 and a light emitting diode which needs to be disposed on the first reflection electrode may not be transferred or missing.

When the first light emitting diode LED1 is disposed on the second reflection electrode RE2 and the light emitting diode which needs to be disposed on the first reflection electrode is not be transferred or missing, a top surface of the first reflection electrode RE1 may be exposed. Further, the insulating pattern IDP may be disposed on the exposed first reflection electrode RE1. In this case, the other components are the same as described above except that the positions of the insulating pattern IDP and the first light emitting diode LED1 are changed.

For example, the first connection electrode CE1 connected to the power line VL may be electrically connected to the first reflection electrode RE1. The second connection electrode CE2 which is connected to the driving transistor DT may be electrically connected to the first electrode 124 of the first light emitting diode LED1. Next, the third connection electrode CE3 may electrically connect the second electrode 125 of the first light emitting diode LED1 and the first reflection electrode RE1.

In the present disclosure, the components electrically connecting the first light emitting diode LED1 and the power line VL or the driving transistor DT may also be collectively referred to as a conductive pattern. For example, the conductive pattern may include the first reflection electrode RE1 (also referred to as a conductive layer), the second reflection electrode RE2 (also referred to as a conductive layer), the first connection electrode CE1 (also referred to as a contact electrode), the second connection electrode CE2 (also referred to as a contact electrode), the third connection electrode CE3 (also referred to as a contact electrode), the insulating pattern IDP, the first planarization layer PAC1, the second planarization layer PAC2, the first additional electrode AE1, the second additional electrode AE2, and the like. In other words, the conductive pattern may include a conductive layer, which is different from the conductive layer TM of the driving transistor DT, as described below with reference to FIG. 4.

A black matrix BM may be disposed on the first connection electrode CE1, the second connection electrode CE2, and the third connection electrode CE3.

The black matrix BM may be disposed to be spaced apart from the first light emitting diode LED1 and the insulating pattern IDP with a predetermined interval. The black matrix BM may be disposed along a contact hole of the second planarization layer PAC2. The black matrix BM may be formed of an opaque material so as to reduce color mixture between the plurality of sub pixels SP and for example, may be formed of black resin, but is not limited thereto.

A third planarization layer PAC3 may be disposed on the black matrix BM.

The third planarization layer PAC3 covers lower configurations including the first light emitting diode LED1 to protect the configurations. The third planarization layer PAC3 may be configured by a single layer or a double layer, and for example, may be formed of an acrylic organic material, but is not limited thereto.

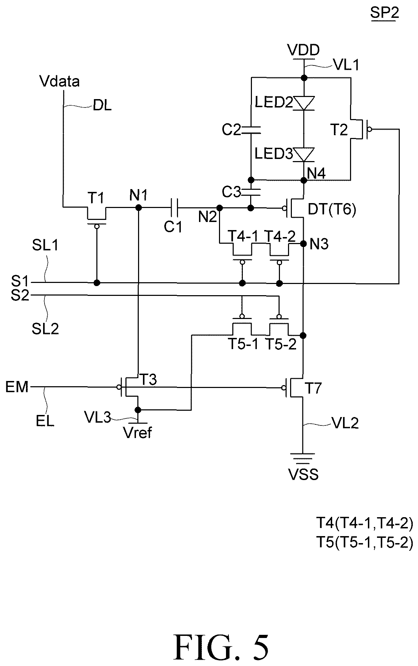

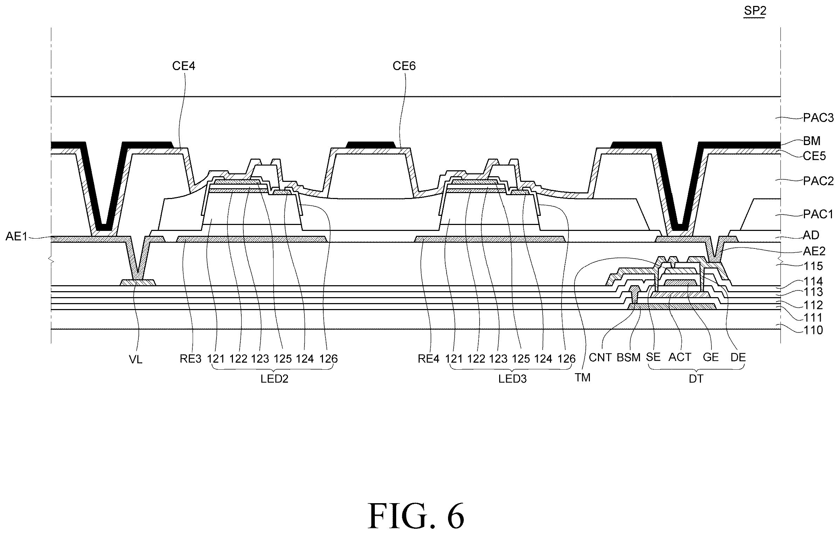

Next, a second sub pixel in which a light emitting diode is normally transferred will be described with reference to FIGS. 5 and 6 together.

FIG. 5 is a circuit diagram of a second sub pixel of a display device according to an exemplary embodiment of the present disclosure. FIG. 6 is a cross-sectional view of a second sub pixel of a display device according to an exemplary embodiment of the present disclosure.

First, referring to FIG. 5, the second sub pixel SP2 includes a second light emitting diode LED2 and a third light emitting diode LED3. The second light emitting diode LED2 and the third light emitting diode LED3 may be connected to each other in series. For example, an anode electrode of the second light emitting diode LED2 may be connected to the high potential voltage line VL1 and a cathode electrode may be connected to an anode electrode of the third light emitting diode LED3. A cathode electrode of the third light emitting diode LED3 may be connected to the sixth transistor T6 through the fourth node N4.

The pixel circuit of the second sub pixel SP2 of FIG. 5 is different from the pixel circuit of the first sub pixel SP1 of FIG. 3 only in the number of light emitting diodes, so that a redundant description will be omitted.

Next, referring to FIG. 6, the components are substantially the same as the component of the first sub pixel SP1 of FIG. 4 except that in the second sub pixel SP2 of FIG. 6, the second light emitting diode LED2 is disposed on the third reflection electrode RE3 and the third light emitting diode LED3 is disposed on the fourth reflection electrode RE4. Therefore, a redundant description will be omitted. That is, unless the components disposed in the second sub pixel SP2 are specifically described, the same contents as described for the first sub pixel SP1 may be applied.

Specifically, in the second sub pixel SP2, the second light emitting diode LED2 and the third light emitting diode LED3 may be disposed on the third reflection electrode RE3 and the fourth reflection electrode RE4, respectively.

The second light emitting diode LED2 and the third light emitting diode LED3 may be fixed onto the third reflection electrode RE3 and the fourth reflection electrode RE4 by the adhesive layer AD, similar to the first light emitting diode LED1, respectively.

The second light emitting diode LED2 and the third light emitting diode LED3 may emit same color light. For example, if the second light emitting diode LED2 is a red light emitting diode which emits red light, the third light emitting diode LED3 may also be the red light emitting diode. In this case, the second sub pixel SP2 may be a red sub pixel RSP. If the second light emitting diode LED2 is a green light emitting diode which emits green light, the third light emitting diode LED3 may also be the green light emitting diode. In this case, the second sub pixel SP2 may be a green sub pixel GSP. If the second light emitting diode LED2 is a blue light emitting diode which emits blue light, the third light emitting diode LED3 may also be the blue light emitting diode. In this case, the second sub pixel SP2 may be a blue sub pixel BSP.

Any one of the second light emitting diode LED2 and the third light emitting diode LED3 may be a main (or primary) light emitting diode and the other one may be a redundancy light emitting diode, but are not limited thereto. The redundancy light emitting diode may be an extra light emitting diode which is transferred in preparation of a defect of the main light emitting diode. If the main light emitting diode is defective, the redundancy light emitting diode may be used instead. Accordingly, the main light emitting diode and the redundancy light emitting diode are transferred to one sub pixel together to minimize the degradation of a display quality due to the defect of the main light emitting diode or the redundancy light emitting diode.

In the second sub pixel SP2, the second light emitting diode LED2 and the third light emitting diode LED3 may be fixed to the third reflection electrode RE3 and the fourth reflection electrode RE4 through the adhesive layer AD, respectively. The adhesive layer AD may include a protrusion in an area overlapping the second light emitting diode LED2. Further, the adhesive layer AD may include a protrusion in an area overlapping the third light emitting diode LED3. Therefore, in the second sub pixel SP2, the adhesive layer AD may include a plurality of protrusions. Further, the adhesive layer AD may include a step in the area overlapping the third reflection electrode RE3. Further, the adhesive layer AD may include a step in the area overlapping the fourth reflection electrode RE4.

In the second sub pixel SP2, the first planarization layer PAC1 may be disposed so as to enclose side surfaces of the second light emitting diode LED2 and the third light emitting diode LED3. Therefore, the first planarization layer PAC1 may be in contact with at least a part of the side surfaces of the second light emitting diode LED2 and the third light emitting diode LED3. The first planarization layer PAC1 may be filled between the second light emitting diode LED2 and the third light emitting diode LED3.

The first planarization layer PAC1 may not overlap top surfaces of the second light emitting diode LED2 and the third light emitting diode LED3. That is, a maximum height of the first planarization layer PAC1 may be lower than maximum heights of the second light emitting diode LED2 and the third light emitting diode LED3. For example, the maximum height of the first planarization layer PAC1 may be lower than the first electrode 124 and the second electrode 125 of each of the second light emitting diode LED2 and the third light emitting diode LED3. The height of the top surface of the first planarization layer PAC1 may be lower as it is farther away from each of the second light emitting diode LED2 and the third light emitting diode LED3.

In the second sub pixel SP2, the second planarization layer PAC2 may be disposed on the first planarization layer PAC1. The second planarization layer PAC2 may be disposed to be spaced apart from the second light emitting diode LED2 and the third light emitting diode LED3.

The second planarization layer PAC2 may overlap a part of top surfaces of the second light emitting diode LED2 and the third light emitting diode LED3. At this time, the second planarization layer PAC2 may not overlap the first electrode 124 and the second electrode 125 of each light emitting diode of the second light emitting diode LED2 and the third light emitting diode LED3.

The second planarization layer PAC2 may cover a side surface of the first planarization layer PAC1. The second planarization layer PAC2 may be filled in an opening which is formed in the adhesive layer AD and the first planarization layer PAC1 to expose a part of top surfaces of the first additional electrode AE1 and the second additional electrode AE2. However, the second planarization layer PAC2 may include a plurality of contact holes to connect the first electrode 124 and the second electrode 125 and the first additional electrode AE1 and the second additional electrode AE2 to each other. For example, the plurality of contact holes may be used to connect the first electrode 124 of the third light emitting diode LED3 and the second additional electrode AE2 to each other and connect the second electrode 125 of the second light emitting diode LED2 and the first additional electrode AE1 to each other.

A fourth connection electrode CE4, a fifth connection electrode CE5, and a sixth connection electrode CE6 are disposed on the second planarization layer PAC2.

The fourth connection electrode CE4 is electrically connected to the power line VL. The fourth connection electrode CE4 may electrically connect the power line VL and the second light emitting diode LED2. For example, the fourth connection electrode CE4 may electrically connect the power line VL and the second electrode 125 of the second light emitting diode LED2. The fourth connection electrode CE4 extends along a part of the plurality of contact holes of the second planarization layer PAC2 to be in contact with the first additional electrode AE1 which is connected to the power line VL.

The fifth connection electrode CE5 may electrically connect the driving transistor DT and the third light emitting diode LED3. For example, the fifth connection electrode CE5 may electrically connect the drain electrode DE of the driving transistor DT and the first electrode 124 of the third light emitting diode LED3. The fifth connection electrode CE5 extends along another part of the plurality of contact holes of the second planarization layer PAC2 to be in contact with the second additional electrode AE2 which is connected to the driving transistor DT.

The sixth connection electrode CE6 may electrically connect the second light emitting diode LED2 and the third light emitting diode LED3. For example, the sixth connection electrode CE6 may electrically connect the first electrode 124 of the second light emitting diode LED2 and the second electrode 125 of the third light emitting diode LED3.

The fourth connection electrode CE4 and the sixth connection electrode CE6 may be spaced apart from each other above the second planarization layer PAC2 overlapping the second light emitting diode LED2. Further, the fifth connection electrode CE5 and the sixth connection electrode CE6 may be spaced apart from each other above the third planarization layer PAC3 overlapping the third light emitting diode LED3.

Hereinafter, a manufacturing method of a first sub pixel of a display device according to an exemplary embodiment of the present disclosure will be described in detail with reference to FIGS. 7A to 7F.

FIGS. 7A to 7F are process diagrams for explaining a manufacturing method of a first sub pixel of a display device according to an exemplary embodiment of the present disclosure.

First, referring to FIG. 7A, the first additional electrode AE1, the second additional electrode AE2, the first reflection electrode RE1, and the second reflection electrode RE2 may be disposed on the substrate 110. A material for forming an adhesive layer AD is applied on the first additional electrode AE1, the second additional electrode AE2, the first reflection electrode RE1 and the second reflection electrode RE2 to form an adhesive layer AD.

The first light emitting diode LED1 may be transferred in an area (e.g. a first area) overlapping the first reflection electrode RE1 on the applied adhesive layer AD. At this time, the light emitting diode is not transferred or missing in an area (e.g. a second area) overlapping the second reflection electrode RE2. After transferring the first light emitting diode LED1, a process of primarily etching the adhesive layer AD may be performed. By doing this, an area other than an area overlapping the first light emitting diode LED1 in the adhesive layer AD may be etched. Therefore, in the adhesive layer AD, a protrusion may be formed in an area overlapping the first light emitting diode LED1.

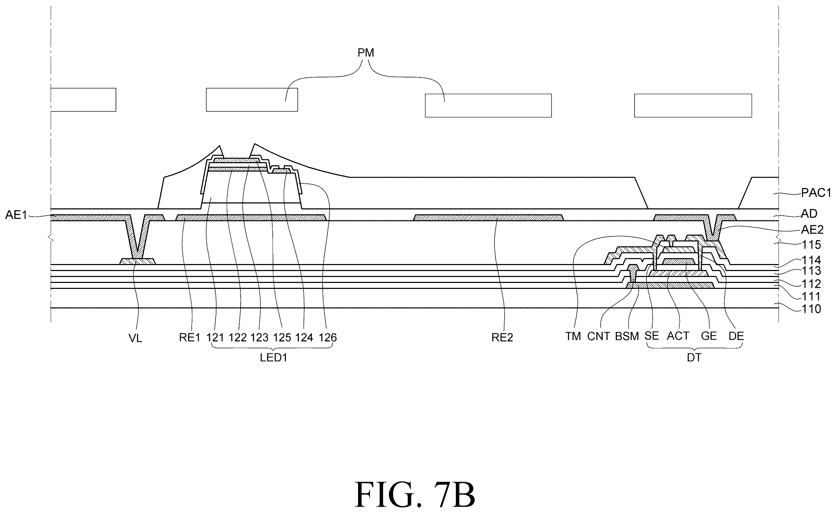

Next, referring to FIG. 7B, a material for forming the first planarization layer PAC1 is applied on the adhesive layer AD to form the first planarization layer PAC1. At this time, the first planarization layer PAC1 may cover an upper portion of the first light emitting diode LED1. Next, a primary etching process of the first planarization layer PAC1 to expose the adhesive layer AD in an area overlapping the first additional electrode AE1 and the second additional electrode AE2 may be performed.

Next, a pattern mask PM may be disposed in an area which overlaps at least a part of the first additional electrode AE1, the second additional electrode AE2, the first light emitting diode LED1, and the second reflection electrode RE2 and a negative etching process may be performed.

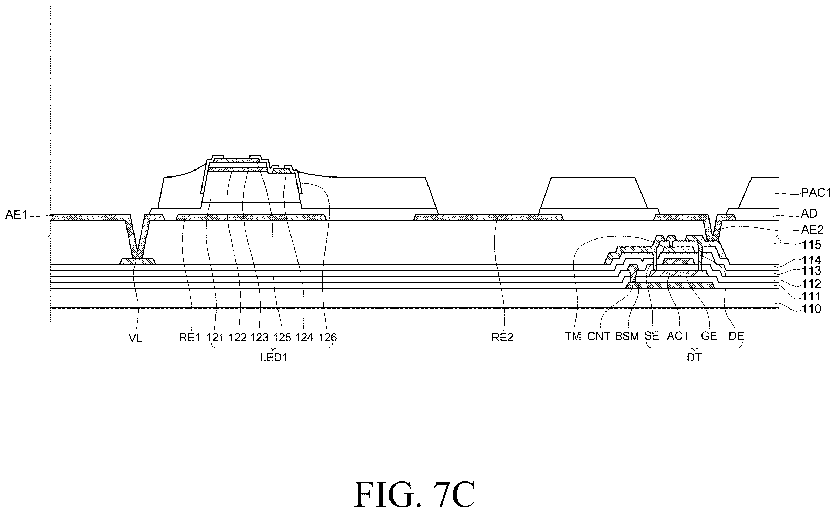

By doing this, as illustrated in FIG. 7C, a top surface of the first light emitting diode LED1 and the second reflection electrode RE2 may be exposed. Further, the adhesive layer AD which overlaps each of the first additional electrode AE1 and the second additional electrode AE2 may be etched. Therefore, the first additional electrode AE1 and the second additional electrode AE2 may be exposed.

Even though it has been described in the present disclosure that the etching process of the first planarization layer PAC1 is negative etching, the present disclosure is not limited thereto. For example, the first planarization layer PAC1 may also be etched by a positive etching process. In this case, the pattern mask may be disposed in an area excluding an area to be etched.

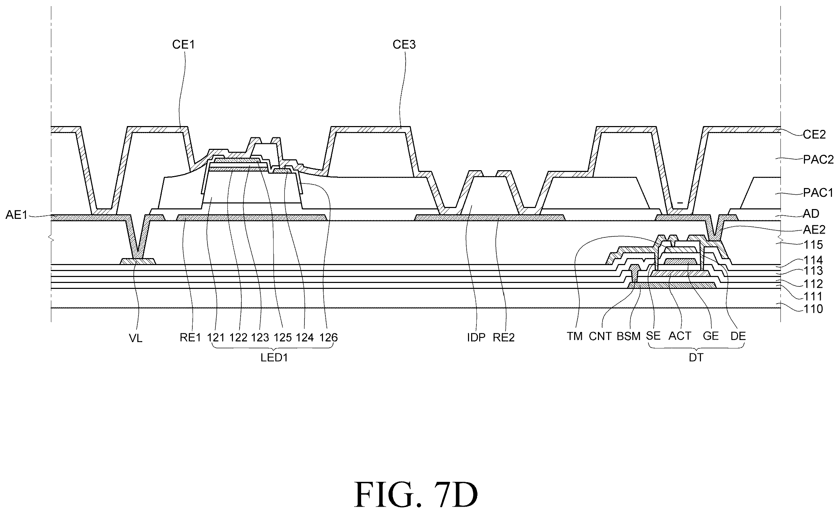

Next, referring to FIG. 7D, a process of placing a second planarization layer PAC2 on the first planarization layer PAC1 may be performed. Further, after placing the second planarization layer PAC2, an etching process for exposing the first electrode 124 and the second electrode 125 of the first light emitting diode LED1 may be performed. During this etching process, in order to suppress the first electrode 124 and the second electrode 125 of the first light emitting diode LED1 from being electrically connected, the second planarization layer PAC2 may be patterned so as to remain a part of the second planarization layer PAC2 between the first electrode 124 and the second electrode 125 on the first light emitting diode LED1, i.e., remain on a portion of the exposed surface of the first region. At this time, in a normal state, the light emitting diode is also disposed on the second reflection electrode RE2 so that the etching process of the second planarization layer PAC2 may be performed by assuming that the light emitting diode is normally disposed on the second reflection electrode RE2. When the light emitting diode is normally transferred onto the second reflection electrode RE2, the second planarization layer PAC2 may be patterned to be partially remained between the first electrode and the second electrode of the light emitting diode, also on the transferred light emitting diode, similar to the first light emitting diode LED1. However, in the first sub pixel SP1 according to the exemplary embodiment of the present disclosure, the light emitting diode is not transferred or missing on the second reflection electrode RE2. Therefore, the second planarization layer PAC2 which needs to remain between the first electrode and the second electrode on the light emitting diode is disposed on the second reflection electrode RE2 exposed in FIG. 7C to serve as an insulating pattern IDP. Therefore, a portion of the second planarization layer PAC2 remains on a portion of the exposed surface of the second region. Therefore, the insulating pattern IDP may be disposed to be spaced apart from the first planarization layer PAC1 and the second planarization layer PAC2. Further, a contact hole for exposing a part of the first additional electrode AE1 and the second additional electrode AE2 may be formed in the second planarization layer PAC2 by the same process, together.

Next, a process of placing the first connection electrode CE1, the second connection electrode CE2, and the third connection electrode CE3 on the second planarization layer PAC2 may be performed. At this time, the first connection electrode CE1 may be disposed so as to be connected to the second electrode 125 of the first light emitting diode LED1. Further, the third connection electrode CE3 may be disposed so as to be connected to the first electrode 124. However, the first electrode 124 and the second electrode 125 of the first light emitting diode LED1 should not be electrically connected to each other. Therefore, the first connection electrode CE1 and the third connection electrode CE3 may be disposed to be spaced apart from each other on the second planarization layer PAC2 formed on the first light emitting diode LED1. As described above, in a normal case, the light emitting diode should be normally disposed on the second reflection electrode RE2 so that the transfer or placing process may be performed by assuming that the light emitting diode is normally transferred onto the second reflection electrode RE2. If it is assumed that the light emitting diode is normally transferred onto the second reflection electrode RE2, the third connection electrode CE3 should be connected to the second electrode of the light emitting diode and the second connection electrode CE2 should be connected to the first electrode. Therefore, the third connection electrode CE3 and the second connection electrode CE2 may be disposed to be spaced apart from each other. However, in the first sub pixel SP1 according to the exemplary embodiment of the present disclosure, the light emitting diode is not transferred or missing on the second reflection electrode RE2 so that an insulating pattern IDP, instead of the light emitting diode, may be formed on the second reflection electrode RE2. Therefore, the third connection electrode CE3 and the second connection electrode CE2 may be disposed to be spaced apart from each other on the insulating pattern IDP. Further, each of the third connection electrode CE3 and the second connection electrode CE2 may be disposed to be in contact with the second reflection electrode RE2 exposed in the vicinity of the insulating pattern IDP. During this process, the third connection electrode CE3 and the second connection electrode CE2 may be electrically connected by the second reflection electrode RE2. Therefore, even though the light emitting diode is not transferred or missing on the second reflection electrode RE2, the first electrode 124 of the first light emitting diode LED1 and the driving transistor DT may be electrically connected.

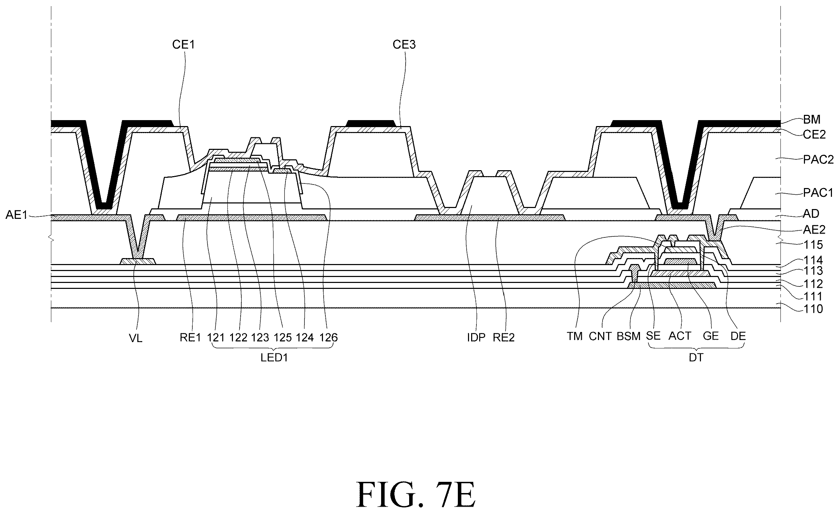

Next, referring to FIG. 7E, a process of placing a black matrix BM on the first connection electrode CE1, the second connection electrode CE2, and the third connection electrode CE3 may be performed. At this time, the black matrix BM may be disposed to be spaced apart from the first light emitting diode LED1 and the insulating pattern IDP so as not to overlap.

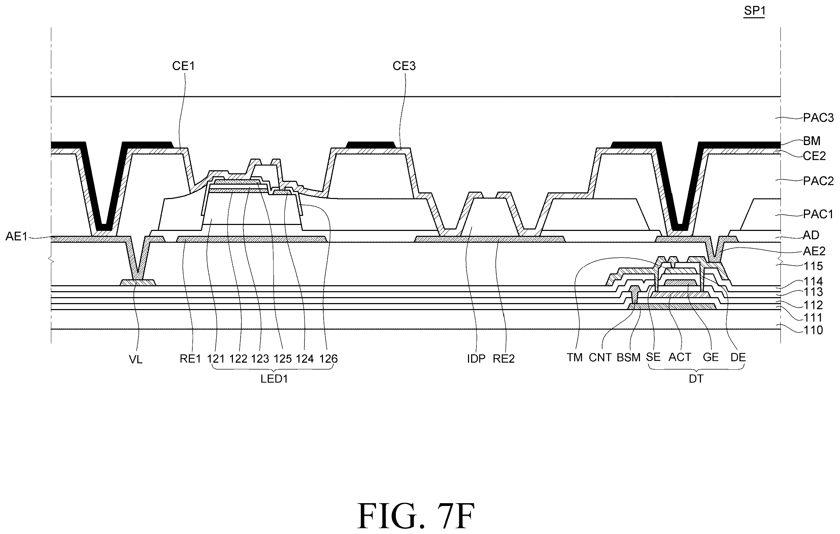

Finally, referring to FIG. 7F, a manufacturing process of the first sub pixel SP1 of the display device 100 may be completed by applying a material to form the third planarization layer PAC3 on the black matrix BM.

A display device which uses the micro LED as a light emitting diode is manufactured by forming a plurality of micro LEDs on a wafer and transferring the micro LEDs onto the substrate of the display device. However, during the process of transferring (transfer process) the plurality of micro LEDs having a micro size from the wafer to the substrate, various defects may be caused. For example, in some sub pixels, a defect that the micro LED is not transferred or missing may occur. Accordingly, in consideration of the defects during the transfer process of the plurality of micro LEDs, a plurality of micro LEDs which emits the same color light may be transferred in one sub pixel.

As described above, when the plurality of micro LEDs is transferred in one sub pixel, the plurality of micro LEDs is connected in parallel so that even though a defect that any one micro LED is not transferred or missing occurs, the other micro LED is normally driven. However, when the plurality of micro LEDs is connected in parallel, there may be a problem in that the power consumption for driving the display device is increased.

As described above, in order to suppress the increase of the power consumption, the plurality of micro LEDs may be connected in series in one sub pixel. However, if the plurality of micro LEDs is connected in series, when a defect that any one micro LED is not transferred or missing occurs, the other micro LED is not electrically connected so that the corresponding sub pixel serves as a dark spot, which degrades the reliability of the display device. Therefore, in order to repair the sub pixel which serves as a dark spot to be operated as a normal pixel, there is a problem in that a separate repair process for connecting a wiring line in a position where the defect occurs is additionally necessary.

Therefore, in the display device 100 according to the exemplary embodiment of the present disclosure, when a defect that the light emitting diode is not transferred or missing in one sub pixel SP1 occurs, the second reflection electrode RE2 in which the light emitting diode is not disposed may be exposed. Further, the exposed second reflection electrode RE2, the first light emitting diode LED1 which is normally transferred, the driving transistor DT or the power line VL may be electrically connected, respectively. Therefore, the area where the light emitting diode is not transferred is automatically repaired during the manufacturing process without a separate repair process.

As described above, in the display device 100 according to the exemplary embodiment of the present disclosure, in one sub pixel SP1 including an area in which one light emitting diode is not transferred, automatic electrical connection of the other light emitting diode is caused. Therefore, the first sub pixel SP1 which serves as a dark spot may operate as a normal sub pixel without a separate repair process. Accordingly, the display device 100 according to the exemplary embodiment of the present disclosure does not need a separate repair process so that a process time may be shortened and a manufacturing process efficiency may be improved.

Further, in the display device 100 according to the exemplary embodiment of the present disclosure, a plurality of light emitting diodes LED2 and LED3 disposed in one sub pixel SP2 may be connected in series. Therefore, the power consumption consumed to drive the display device 100 may be reduced.

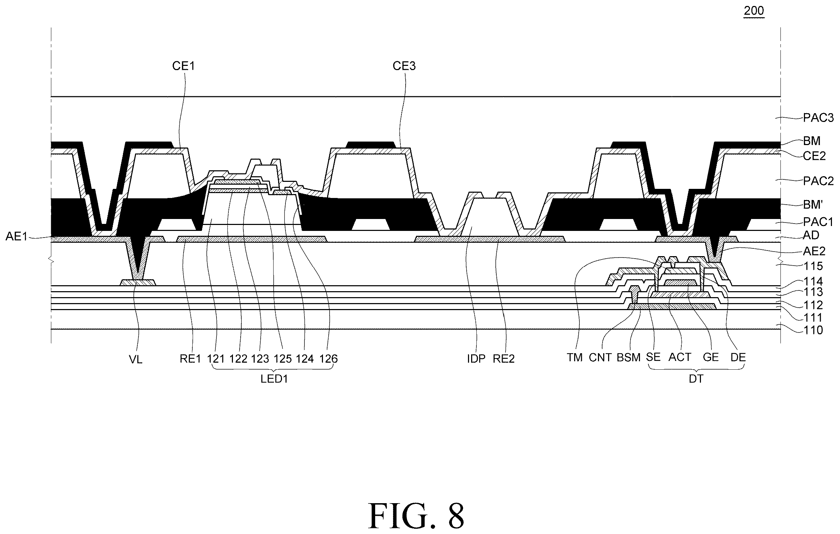

FIG. 8 is a cross-sectional view of a first sub pixel of a display device according to another exemplary embodiment of the present disclosure. Components of a first sub pixel SP1 of FIG. 8 are substantially the same as those of the first sub pixel SP1 of FIG. 4 except that an additional black matrix BM' is further included between the first planarization layer PAC1 and the second planarization layer PAC2. Therefore, a redundant description will be omitted.

Referring to FIG. 8, the first planarization layer PAC1 may be disposed on the adhesive layer AD so as to enclose the first light emitting diode LED1. Therefore, the first planarization layer PAC1 is not in contact with the side surface of the first light emitting diode LED1, and is disposed to be spaced apart from the first planarization layer PAC1. Further, the first planarization layer PAC1 may be disposed on the adhesive layer AD so as to enclose the insulating pattern IDP. At this time, the first planarization layer PAC1 may be disposed so as to be spaced apart from the insulating pattern IDP. A height of the top surface of the first planarization layer PAC1 may be smaller than a height of the top surface of the first light emitting diode LED 1. Further, the height of the top surface of the first planarization layer PAC1 may be smaller than a height of the top surface of the insulating pattern IDP. The first planarization layer PAC1 may not overlap the opening of the adhesive layer AD.

For example, the first planarization layer PAC1 may be configured by benzocyclobutene or an acrylic organic material, but is not limited thereto.

An additional black matrix BM' may be disposed on the first planarization layer PAC1. The additional black matrix BM' may be disposed between the first planarization layer PAC1 and the second planarization layer PAC2. The additional black matrix BM' may cover a top surface and a side surface of the first planarization layer PAC1. For example, the additional black matrix BM' may completely cover the entire first planarization layer PAC1.

The additional black matrix BM' may be disposed so as to enclose a side surface of the first light emitting diode LED1. Specifically, the additional black matrix BM' may be in contact with at least a part of the side surface of the first light emitting diode LED1. Therefore, the additional black matrix BM' may be filled in a space formed when the first light emitting diode LED1 is spaced apart from the first planarization layer PAC1. Further, the additional black matrix BM' may be filled in the opening of the adhesive layer AD. For example, the additional black matrix BM' may be disposed on the first additional electrode AE1 and the second additional electrode AE2 exposed through the opening of the adhesive layer AD. Further, the additional black matrix BM' may be filled in a contact hole formed in the overcoating layer 115 on the first additional electrode AE1 and the second additional electrode AE2. A maximum height of the additional black matrix BM' may be smaller than a maximum height of the first light emitting diode LED1. For example, a maximum height of the additional black matrix BM' may be lower than a top surface of the second electrode 125 of the first light emitting diode LED1. The more adjacent to the first light emitting diode LED1, the larger the height of the additional black matrix BM'.

The additional black matrix BM' may not overlap a top surface of the first light emitting diode LED1. For example, the additional black matrix BM' may not overlap top surfaces of the first electrode 124 and the second electrode 125 of the first light emitting diode LED1.

The additional black matrix BM' may include an opening which exposes a part of the top surface of the second reflection electrode RE2. At this time, the opening of the additional black matrix BM' may be formed so as to overlap the opening of the adhesive layer AD, on the second reflection electrode RE2. That is, the opening of the additional black matrix BM' may be connected to the opening of the adhesive layer AD, on the second reflection electrode RE2. Therefore, the part of the top surface of the second reflection electrode RE2 may be exposed through the openings of the adhesive layer AD and the additional black matrix BM'.

The additional black matrix BM' may further include a plurality of contact holes. The first connection electrode CE1 and the first additional electrode AE1 may be connected through the plurality of contact holes. Further, the second connection electrode CE2 and the second additional electrode AE2 may be connected through the plurality of contact holes.

For example, the additional black matrix BM' may be formed of black resin, but is not limited thereto.

The second planarization layer PAC2 may be disposed on the additional black matrix BM'. The second planarization layer PAC2 may be disposed so as to be spaced apart from the first light emitting diode LED1. Therefore, the second planarization layer PAC2 may expose a part of the top surface of the additional black matrix BM' adjacent to the first light emitting diode LED1.

An opening of the second planarization layer PAC2 may be connected to the opening of the additional black matrix BM'. Therefore, the opening of the second planarization layer PAC2 and the opening of the additional black matrix BM' are connected to form one opening. The second reflection electrode RE2 may be exposed through the opening formed as described above.

Further, the second planarization layer PAC2 may include a contact hole which is connected to the contact hole of the additional black matrix BM'. Therefore, the contact hole of the second planarization layer PAC2 and the contact hole of the additional black matrix BM' may form one contact hole.

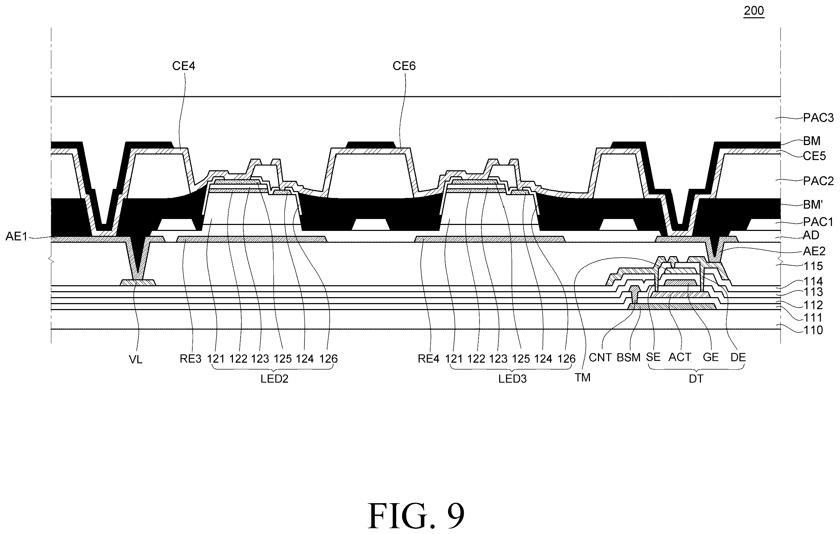

FIG. 9 is a cross-sectional view of a second sub pixel of a display device according to another exemplary embodiment of the present disclosure. Components of a second sub pixel SP2 of FIG. 9 are substantially the same as those of the second sub pixel SP2 of FIG. 6 except that an additional black matrix BM' is further included between the first planarization layer PAC1 and the second planarization layer PAC2. Further, components of the second sub pixel SP2 of FIG. 9 are substantially the same as those of the first sub pixel SP1 of FIG. 8 except that the second light emitting diode LED2 is disposed on the third reflection electrode RE3 and the third light emitting diode LED3 is disposed on the fourth reflection electrode RE4. Therefore, a redundant description will be omitted.

Referring to FIG. 9, the first planarization layer PAC1 may be spaced apart from the second light emitting diode LED2. Further, the first planarization layer PAC1 may be spaced apart from the third light emitting diode LED3. For example, the first planarization layer PAC1 may be disposed to be spaced apart from each of the second light emitting diode LED2 and the third light emitting diode LED3 between the second light emitting diode LED2 and the third light emitting diode LED3.

An additional black matrix BM' may be disposed on the first planarization layer PAC1. The additional black matrix BM' may be filled between the second light emitting diode LED2 and the third light emitting diode LED3. Therefore, one end of the additional black matrix BM' may be in contact with the side surface of the second light emitting diode LED2 and the other end may be in contact with the side surface of the third light emitting diode LED3. A top surface of the additional black matrix BM' may have a concave shape in the middle between the second light emitting diode LED2 and the third light emitting diode LED3, but is not limited thereto. For example, the more adjacent to the second light emitting diode LED2, the larger the height of the top surface of the additional black matrix BM'. Further, the more adjacent to the third light emitting diode LED3, the larger the height of the top surface of the additional black matrix BM'. The additional black matrix BM' may not overlap the first electrode 124 and the second electrode 125 of each of the second light emitting diode LED2 and the third light emitting diode LED3.

The second planarization layer PAC2 may be disposed on the additional black matrix BM'. The second planarization layer PAC2 may be spaced apart from each of the second light emitting diode LED2 and the third light emitting diode LED3 between the second light emitting diode LED2 and the third light emitting diode LED3. Therefore, the additional black matrix BM' may be exposed in a peripheral portion adjacent to each of the second light emitting diode LED2 and the third light emitting diode LED3. The second planarization layer PAC2 may be partially disposed on each of the second light emitting diode LED2 and the third light emitting diode LED3. However, the second planarization layer PAC2 disposed on the second light emitting diode LED2 and the third light emitting diode LED3 may not overlap the first electrode 124 and the second electrode 125 of each of the second light emitting diode LED2 and the third light emitting diode LED3.

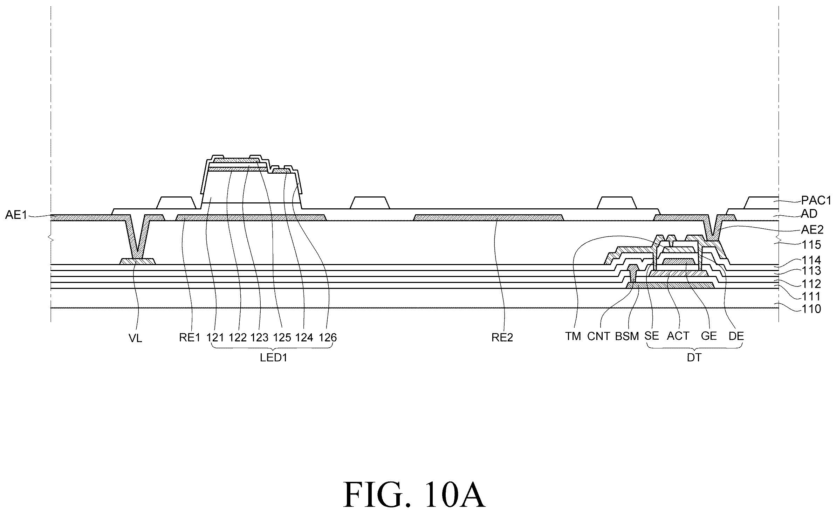

Hereinafter, a manufacturing method of a first sub pixel of a display device according to another exemplary embodiment of the present disclosure will be described in detail with reference to FIGS. 10A to 10E.

FIGS. 10A to 10E are process diagrams for explaining a manufacturing method of a first sub pixel of a display device according to another exemplary embodiment of the present disclosure.

First, referring to FIG. 10A, the first additional electrode AE1, the second additional electrode AE2, the first reflection electrode RE1, and the second reflection electrode RE2 may be disposed on the substrate 110. A material for forming an adhesive layer AD is applied on the first additional electrode AE1, the second additional electrode AE2, the first reflection electrode RE1 and the second reflection electrode RE2 to form an adhesive layer AD.

The first light emitting diode LED1 may be transferred in an area overlapping the first reflection electrode RE1 on the applied adhesive layer AD. At this time, the light emitting diode may not be transferred or missing in an area overlapping the second reflection electrode RE2. After transferring the first light emitting diode LED 1, a process of primarily etching the adhesive layer AD may be performed. By doing this, an area other than an area overlapping the first light emitting diode LED1 in the adhesive layer AD may be etched. Therefore, in the adhesive layer AD, a protrusion may be formed in an area overlapping the first light emitting diode LED1.

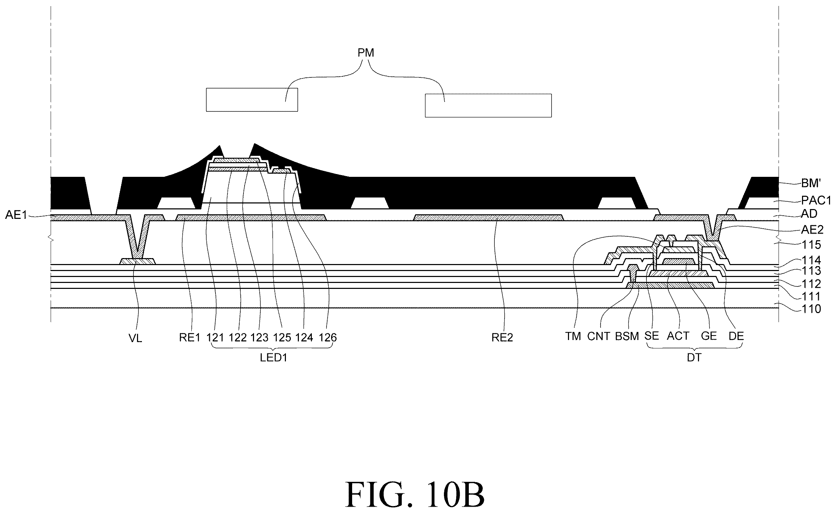

Next, referring to FIG. 10B, a material for forming the first planarization layer PAC1 is applied on the adhesive layer AD to form the first planarization layer PAC1. An etching process may be performed to separate the first planarization layer PAC1 from the first light emitting diode LED1. The first planarization layer PAC1 may be spaced apart from the first light emitting diode LED1 In the case where it is assumed that the light emitting diode is normally transferred onto the second reflection electrode RE2, the first planarization layer PAC1 is also spaced apart from the light emitting diode. Therefore, the first planarization layer PAC1 may be spaced apart from the placement area of the two light emitting diodes. Further, during this process, the adhesive layer AD on the first additional electrode AE1 and the second additional electrode AE2 is etched to expose the first additional electrode AE1 and the second additional electrode AE2. Further, the second reflection electrode RE2 may be exposed by another etching process as described below.

Next, the additional black matrix BM' may be formed by applying a material for forming the additional black matrix BM' on the first planarization layer PAC1. At this time, the additional black matrix BM' may cover the upper portion of the first light emitting diode LED1. Next, a primary etching process may be performed to etch an area overlapping the first additional electrode AE1 and the second additional electrode AE2. Therefore, the first additional electrode AE1 and the second additional electrode AE2 may be exposed.

Next, a pattern mask PM is disposed in an area overlapping at least a part of the first light emitting diode LED1 and the second reflection electrode RE2 and a negative etching process may be performed. By doing this, a top surface of the first light emitting diode LED1 and the second reflection electrode RE2 may be exposed.

Even though it is described in the present disclosure, that the etching process of the additional black matrix BM' includes a negative etching, the present disclosure is not limited thereto. For example, the additional black matrix BM' may also be etched by a positive etching process. In this case, the pattern mask may be disposed in an area excluding an area to be etched.

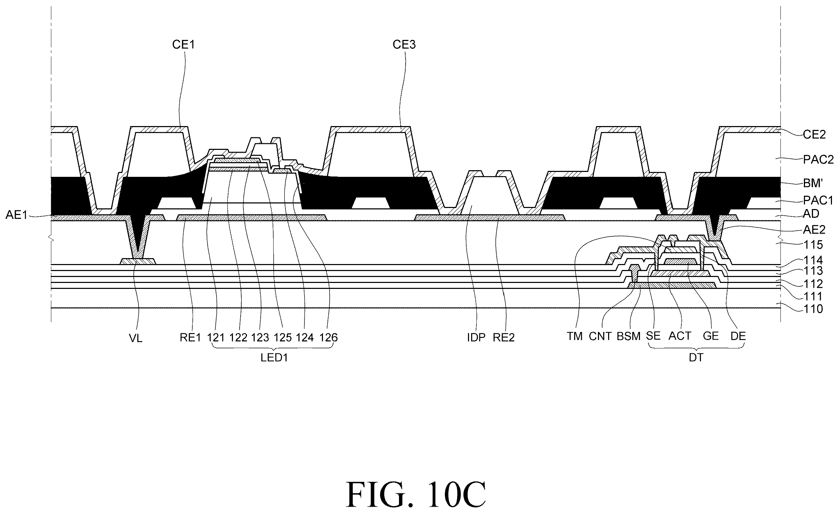

Next, referring to FIG. 10C, a process of placing a second planarization layer PAC2 on the additional black matrix BM' may be performed. Further, after placing the second planarization layer PAC2, an etching process for exposing the first electrode 124 and the second electrode 125 of the first light emitting diode LED1 may be performed. During this etching process, in order to suppress the first electrode 124 and the second electrode 125 of the first light emitting diode LED1 from being electrically connected, the second planarization layer PAC2 may be patterned so as to remain a part of the second planarization layer PAC2 between the first electrode 124 and the second electrode 125 on the first light emitting diode LED1. At this time, in a normal state, the light emitting diode is also disposed on the second reflection electrode RE2 so that the etching process of the second planarization layer PAC2 may be performed by assuming that the light emitting diode is normally disposed on the second reflection electrode RE2. When the light emitting diode is normally transferred onto the second reflection electrode RE2, the second planarization layer PAC2 may be patterned to be partially remained between the first electrode and the second electrode of the light emitting diode, also on the transferred light emitting diode, similar to the first light emitting diode LED1. However, in the first sub pixel SP1 according to the exemplary embodiment of the present disclosure, the light emitting diode is not transferred or missing on the second reflection electrode RE2. Therefore, the second planarization layer PAC2 which needs to remain between the first electrode and the second electrode on the light emitting diode is disposed on the second reflection electrode RE2 exposed in FIG. 10B to serve as an insulating pattern IDP. Therefore, the insulating pattern IDP may be disposed to be spaced apart from the additional black matrix BM' and the second planarization layer PAC2. Further, a contact hole for exposing a part of the first additional electrode AE1 and the second additional electrode AE2 may be formed in the second planarization layer PAC2 by the same process, together.

Next, a process of placing the first connection electrode CE1, the second connection electrode CE2, and the third connection electrode CE3 on the second planarization layer PAC2 may be performed. At this time, the first connection electrode CE1 may be disposed so as to be connected to the second electrode 125 of the first light emitting diode LED1. Further, the third connection electrode CE3 may be disposed so as to be connected to the first electrode 124. However, the first electrode 124 and the second electrode 125 of the first light emitting diode LED1 should not be connected to each other. Therefore, the first connection electrode CE1 and the third connection electrode CE3 may be disposed to be spaced apart from each other on the second planarization layer PAC2 formed on the first light emitting diode LED1. As described above, in a normal case, the light emitting diode should be normally disposed on the second reflection electrode RE2 so that the process may be performed by assuming that the light emitting diode is normally transferred onto the second reflection electrode RE2. If it is assumed that the light emitting diode is normally transferred onto the second reflection electrode RE2, the third connection electrode CE3 should be connected to the second electrode of the light emitting diode and the second connection electrode CE2 should be connected to the first electrode. Therefore, the third connection electrode CE3 and the second connection electrode CE2 may be disposed to be spaced apart from each other. However, in the first sub pixel SP1 according to the exemplary embodiment of the present disclosure, the light emitting diode is not transferred or missing on the second reflection electrode RE2 so that an insulating pattern IDP, instead of the light emitting diode, may be formed on the second reflection electrode RE2. Therefore, the third connection electrode CE3 and the second connection electrode CE2 may be disposed to be spaced apart from each other on the insulating pattern IDP. Further, each of the third connection electrode CE3 and the second connection electrode CE2 may be disposed to be in contact with the second reflection electrode RE2 exposed in the vicinity of the insulating pattern IDP. During this process, the third connection electrode CE3 and the second connection electrode CE2 may be electrically connected by the second reflection electrode RE2. Therefore, even though the light emitting diode is not transferred or missing on the second reflection electrode RE2, the first electrode 124 of the first light emitting diode LED1 and the driving transistor DT may be electrically connected.

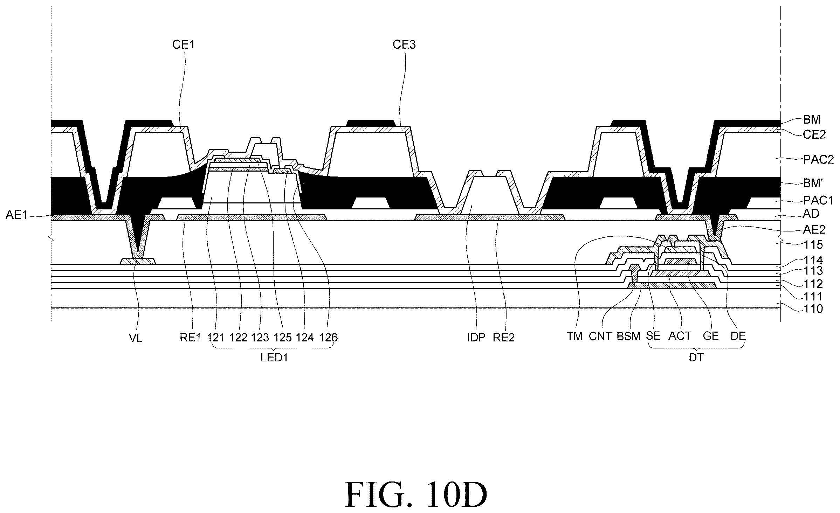

Next, referring to FIG. 10D, a process of placing a black matrix BM on the first connection electrode CE1, the second connection electrode CE2, and the third connection electrode CE3 may be performed. At this time, the black matrix BM may be disposed to be spaced apart from the first light emitting diode LED1 and the insulating pattern IDP so as not to overlap.

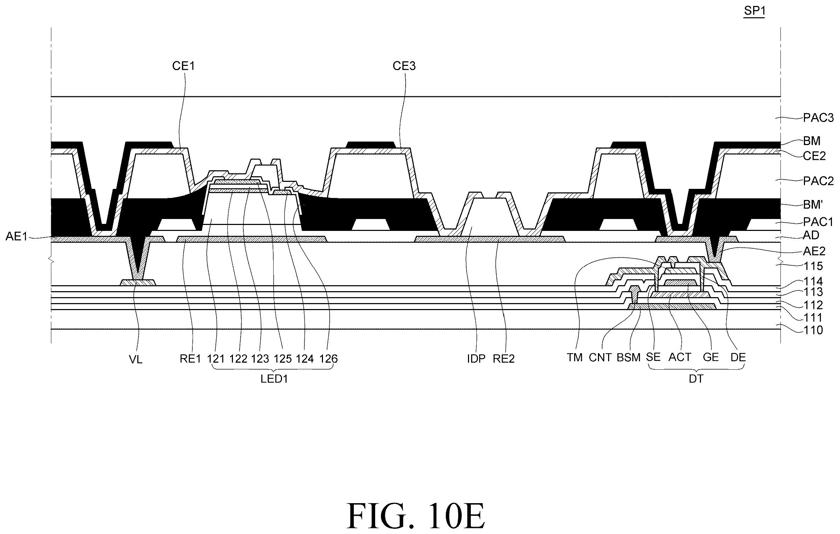

Finally, referring to FIG. 10E, a manufacturing process of the first sub pixel SP1 of another display device 200 of the present disclosure may be completed by a process of applying a material to form the third planarization layer PAC3 on the black matrix BM.

In the display device 200 according to another exemplary embodiment of the present disclosure, when a defect that the light emitting diode is not transferred or missing in one sub pixel SP1 occurs, the second reflection electrode RE2 in which the light emitting diode is not disposed may be exposed. Further, the exposed second reflection electrode RE2, the first light emitting diode LED1 which is normally transferred, the driving transistor DT or the power line VL may be electrically connected, respectively. Therefore, the area where the light emitting diode is not transferred may be automatically repaired during the manufacturing process without a separate repair process.

As described above, in the display device 200 according to another exemplary embodiment of the present disclosure, the first sub pixel SP1 which serves as a dark spot may operate as a normal sub pixel without a separate repair process. Accordingly, the display device 200 according to the exemplary embodiment of the present disclosure does not need a separate repair process so that a process time may be more shortened and a process efficiency may be more improved.

Further, in the display device 200 according to another exemplary embodiment of the present disclosure, a plurality of light emitting diodes LED2 and LED3 disposed in one sub pixel SP2 may be connected in series. Therefore, the power consumption consumed to drive the display device 200 may be further reduced.

Although the exemplary embodiments of the present disclosure have been described in detail with reference to the accompanying drawings, the present disclosure is not limited thereto and may be embodied in many different forms . Therefore, the exemplary embodiments of the present disclosure are provided for illustrative purposes. It should be understood that the above-described exemplary embodiments are illustrative in all aspects.

## Claims

1. A display device (100, 200), comprising:
a substrate (110) in which a plurality of sub pixels (SP) including a first sub pixel (SP1) is defined;
a power line (VL) disposed on the substrate (110);
a driving transistor (DT) disposed in the first sub pixel (SP1) on the substrate (110);
a conductive pattern which includes a first reflection electrode (RE1) and a second reflection electrode (RE2) disposed on the driving transistor (DT) in the first sub pixel (SP1); and
a first light emitting diode (LED1) disposed on the conductive pattern in the first sub pixel (SP1),
wherein the conductive pattern electrically connects the first light emitting diode (LED1) and the power line (VL) or the driving transistor (DT) disposed in the first sub pixel (SP1).

2. The display device (100, 200) of claim 1, wherein the conductive pattern further includes:
a first connection electrode (CE1) electrically connected to the power line (VL);
a second connection electrode (CE2) electrically connected to the driving transistor (DT); and
a third connection electrode (CE3) which is electrically connected to one of the first connection electrode (CE1) and the second connection electrode (CE2) by the other one of the first reflection electrode (RE1) and the second reflection electrode (RE2) and is electrically connected to the first light emitting diode (LED1).

3. The display device (100, 200) according to claim 1 or 2, further comprising:
an adhesive layer (AD) which is disposed on the first reflection electrode (RE1) and the second reflection electrode (RE2) in the first sub pixel (SP1),
wherein the adhesive layer (AD) is disposed between the one of the first reflection electrode (RE1) and the second reflection electrode (RE2) and the first light emitting diode (LED1) and includes an opening which exposes the other one of the first reflection electrode (RE1) and the second reflection electrode (RE2), preferably wherein each of the first connection electrode (CE1) and the second connection electrode (CE2) is in contact with the other one of the first reflection electrode (RE1) and the second reflection electrode (RE2) exposed by the opening.

4. The display device (100, 200) according to claim 3, further comprising:
an insulating pattern (IDP) which is disposed on the other one of the first reflection electrode (RE1) and the second reflection electrode (RE2) exposed through the opening,
preferably wherein the one of the first connection electrode (CE1) and the second connection electrode (CE2) is spaced apart from the third connection electrode (CE3) on the insulating pattern (IDP).

5. The display device (100, 200) according to claim 3, wherein the one of the first connection electrode (CE1) and the second connection electrode (CE2) and the third connection (CE3) electrode are in contact with the other one of the first reflection electrode (RE1) and the second reflection electrode (RE2) exposed by the opening.

6. The display device (100, 200) according to claim 1, further comprising:
a first planarization layer (PAC1) which is disposed on the first reflection electrode (RE1) and the second reflection electrode (RE2) in the first sub pixel (SP1); and
a second planarization layer (PAC2) disposed on the first planarization layer (PAC1).

7. The display device (100, 200) according to claim 6, wherein the first planarization layer (PAC1) is in contact with at least a part of a side surface of the first light emitting diode (LED 1),
preferably wherein a maximum height of the first planarization layer (PAC1) is lower than a height of a top surface of the first light emitting diode (LED1).

8. The display device (100, 200) according to claim 6, further comprising:
a black matrix (BM) disposed on the second planarization layer (PAC2), the first connection electrode (CE1), the second connection electrode (CE2), and the third connection electrode (CE3); or
a black matrix (BM) disposed between the first planarization layer (PAC1) and the second planarization layer (PAC2),
wherein the first connection electrode (CE1), the second connection electrode (CE2), and the third connection electrode (CE3) are disposed on the second planarization layer (PAC2),
preferably wherein the first planarization layer (PAC1) is spaced apart from the first light emitting diode (LED1) and the black matrix (BM) covers a top surface and a side surface of the first planarization layer (PAC1).

9. The display device (100, 200) according to claim 1, wherein the plurality of sub pixels (SP) further includes a second sub pixel (SP2),
wherein the second sub pixel (SP2) includes:
a third reflection electrode (RE3) and a fourth reflection electrode (RE4) disposed on a driving transistor (DT) in the second sub pixel (SP2);
a second light emitting diode (LED2) disposed on the third reflection electrode (RE3);
a third light emitting diode (LED3) disposed on the fourth reflection electrode (RE4);
preferably wherein the second light emitting diode (LED2) and the third light emitting diode (LED3) emit same color light and are connected in series.

10. The display device of claim 9, further comprising:
a fourth connection electrode (CE4) electrically connected to the power line (VL);
a fifth connection electrode (CE5) electrically connected to the driving transistor (DT) in the second sub pixel (SP2); and
a sixth connection electrode (CE6) electrically connected to the second light emitting diode (LED2) and the third light emitting diode (LED3),
preferably wherein the second light emitting diode (LED2) is electrically connected to the power line (VL) and the third light emitting diode (LED3) is electrically connected to the driving transistor (DT) disposed in the second sub pixel (SP2).

11. The display device (100, 200) according to claim 9, further comprising:
in the second sub pixel (SP2),
an adhesive layer (AD) disposed on the third reflection electrode (RE3) and the fourth reflection electrode (RE4);
a first planarization layer (PAC1) disposed on the adhesive layer (AD); and
a second planarization layer (PAC2) disposed on the first planarization layer (PAC1).

12. The display device (100, 200) according to claim 11, wherein the first planarization layer (PAC1) is in contact with at least a part of side surfaces of the second light emitting diode (LED2) and the third light emitting diode (LED3) and a maximum height of the first planarization layer (PAC1) is lower than a height of a top surface of the second light emitting diode (LED2) or the third light emitting diode (LED3),
preferably wherein the second planarization layer (PAC2) is spaced apart from the second light emitting diode (LED2) or the third light emitting diode (LED3),
the fourth connection electrode (CE4), the fifth connection electrode (CE5), and the sixth connection electrode (CE6) are disposed on the second planarization layer (PAC2), and
a black matrix (BM) is disposed on the fourth connection electrode (CE4), the fifth connection electrode (CE5), and the sixth connection electrode (CE6).

13. The display device (100, 200) according to claim 11, further comprising:
a black matrix (BM) which is disposed between the first planarization layer (PAC1) and the second planarization layer (PAC2) and covers a top surface and a side surface of the first planarization layer (PAC1),
wherein the fourth connection electrode (CE4), the fifth connection electrode (CE5), and the sixth connection electrode (CE6) are disposed on the second planarization layer (PAC2).

14. A method for manufacturing display device, comprising:
transferring, in a transfer process, a first light emitting diode (LED1) and a second light emitting diode (LED2) into a first region overlapping with a first reflection electrode (RE1) on a substrate (110) and a second region overlapping with a second reflection electrode (RE2) on the substrate (110), respectively;
forming a first planarization layer (PAC1) or both a first planarization layer (PAC1) and a black matrix (BM) on the first region and the second region;
etching the first planarization layer (PAC1) or the black matrix (BM) to expose at least a portion of a component below the first planarization layer (PAC 1) or the black matrix (BM), in the first region and the second region;
forming a second planarization layer (PAC2) on the first planarization layer (PAC1) or the black matrix (BM), wherein pattering the second planarization layer (PAC2) so that a portion of the second planarization layer (PAC2) remains on a portion of the exposed surfaces in the first region and the second region; and
forming a plurality of connection electrodes on the second planarization layer (PAC2),
wherein, in the case where the first light emitting diode (LED1) is transferred to the first reflection electrode (RE1) and the second light emitting diode (LED2) is not transferred to the second reflection electrode (RE2) during the transfer process, forming the second planarization layer (PAC2) on the exposed second reflection electrode (RE2), and electrically connecting the first light emitting diode (LED1) to a driving transistor (DT) or a power line (VT) on the substrate (110) through connection electrodes (CE1, CE2, CE3) among the plurality of connection electrodes and the second reflection electrode (RE2).

15. The method according to claim 25, wherein the forming the plurality of connection electrodes includes:
forming a first connection electrode (CE1) electrically connecting the first light emitting diode (LED1) and the second reflection electrode (RE2); and
forming a second connection electrode (CE2) electrically connecting the second reflection electrode (RE2) and the driving transistor (DT) or the power line (VT),
wherein spacing the first connection electrode (CE1) and the second connection electrode (CE2) apart from each other on the second planarization layer (PAC2) formed on the exposed second reflection electrode (RE2),
preferably wherein in the case of forming both a first planarization layer (PAC1) and a black matrix (BM), forming the first planarization layer (PAC1) before forming the black matrix (BM), wherein spacing the first planarization layer (PAC1) apart from a placement area of the first light emitting diode (LED1) and the second light emitting diode (LED2), and the black matrix (BM) covers the top surface and the side surface of the first planarization layer (PAC1).
